# EUROPEAN PATENT SPECIFICATION

(11) **EP 4 443 504 B1**
(45) Date of publication and mention of the grant of the patent: **18.11.2026**
(21) Application number: 24166478.8
(22) Date of filing: 26.03.2024
(51) Int. Cl.: H10H 29/01, H10H 29/37, H10H 29/49, H10H 29/852

(54) **DISPLAY DEVICE AND METHOD OF MANUFACTURING DISPLAY DEVICE**
ANZEIGEVORRICHTUNG UND VERFAHREN ZUR HERSTELLUNG DER ANZEIGEVORRICHTUNG
DISPOSITIF D'AFFICHAGE ET PROCÉDÉ DE FABRICATION DE DISPOSITIF D'AFFICHAGE

(30) Priority: 29.03.2023 KR 20230041356
(43) Date of publication of application: 09.10.2024
(73) Proprietor: Samsung Display Co., Ltd., Yongin-si, Gyeonggi-do 17113 (KR)
(72) Inventor: KIM, Seul Ki, 17113 Yongin-si (KR); SO, Myeong Su, 17113 Yongin-si (KR)
(74) Representative: Walaski, Jan Filip

(56) References cited:
- EP-A1- 3 961 710
- EP-A1- 3 961 711
- US-A1- 2014 159 064
- US-A1- 2014 367 705
- US-A1- 2021 111 303
- US-A1- 2022 093 678
- US-A1- 2022 352 268
- US-A1- 2022 384 403
- US-A1- 2023 060 443
- US-A1- 2023 069 326

## Description

### BACKGROUND

### 1. Technical Field

The invention relates to a display device and a method of manufacturing the display device.

### 2. Description of the Related Art

Recently, as interest in an information display has increased, research and development of display devices has been continuously conducted.
US 2022/0352268 A1 discloses a display device and a method of manufacturing a display device in which a light-emitting element is easily formed.
US 2022/0093678 A1 discloses a display device including pixels.
US 2014/0159064 A1 discloses reflective bank structures for light emitting devices.

### SUMMARY

According to the invention, there is provided a display device as set out in claim 1, and a method of manufacturing a display device as set out in claim 8. An aspect of the invention is to solve a problem occurring in case that a step difference is generated in a common electrode disposed on light emitting elements due to light emitting elements being disposed in an area other than an emission area and the common electrode being disconnected due to the step difference formed in the common electrode.

Another aspect of the invention is to provide a method of manufacturing a display device in which a light emitting element is disposed only in an emission area by removing light emitting elements disposed in an area other than the emission area.

However, aspects of the invention are not limited to the above-described aspects, and may be variously expanded without departing from the scope of the invention as defined by the claims.

According to an embodiment, the second electrode may directly contact the insulating layer disposed on the second surface of the bank.

According to an embodiment, the display device further includes a via layer filling the opening. The second electrode is disposed on the insulating layer, the via layer, and the light emitting elements.

According to an embodiment, the via layer may not be disposed on the second surface of the bank.

According to an embodiment, the via layer may contact the insulating layer overlapping the outer surface of the bank in a plan view.

According to an embodiment, each of the light emitting elements may include a first end and a second end facing the first end, the first end may directly contact the first electrode, and the second end may directly contact the second electrode.

According to an embodiment, each of the light emitting elements may include a second semiconductor layer, an active layer, and a first semiconductor layer different from the second semiconductor layer, which are sequentially stacked on each other in a third direction, the first end of each of the light emitting elements may be adjacent to the second semiconductor layer of each of the light emitting elements, and the second end of each of the light emitting elements may be adjacent to the first semiconductor layer of each of the light emitting elements.

According to an embodiment, the first semiconductor layer of each of the light emitting elements may be an n-type semiconductor layer, and the second semiconductor layer of each of the light emitting elements may be a p-type semiconductor layer.

According to an embodiment, the insulating layer may include a non-photosensitive material.

According to an embodiment, the display device may further include a light control layer on the second electrode. The light control layer may include a first light blocking pattern partitioning an emission area and a non-emission area, a wavelength conversion pattern disposed between the first light blocking pattern and overlapping the emission area in a plan view, a second light blocking pattern disposed on the first light blocking pattern, and color filters disposed on the wavelength conversion pattern.

According to an embodiment, the removing of the first subset of the light emitting elements may include forming a photoresist pattern to overlap the insulating layer and a portion of the first subset of the light emitting elements in a plan view, and removing the first subset of the light emitting elements.

The display device and the method of manufacturing the same according to embodiments of the invention may prevent a step difference from occurring in a common electrode disposed on the light emitting element as the light emitting element may be disposed only in an emission area. Therefore, a phenomenon in which the common electrode is disconnected may be solved, and thus a display device with improved reliability may be provided.

However, an effect of the invention is not limited to the above-described effects, and may be variously expanded without departing from the scope of the invention as defined by the claims.

### BRIEF DESCRIPTION OF THE DRAWINGS

The above and other features of the invention will become more apparent by describing in further detail embodiments thereof with reference to the accompanying drawings, in which:
FIG. 1 is a schematic plan view illustrating a display device;
FIG. 2 is a schematic cross-sectional view illustrating an example of a pixel of FIG. 1;
FIG. 3 is a schematic circuit diagram illustrating an example of a sub-pixel included in the pixel of FIG. 2;
FIG. 4 is a schematic perspective view illustrating a light emitting element included in the sub-pixel of FIG. 2;
FIG. 5 is a schematic cross-sectional view illustrating an example of the light emitting element of FIG. 4;
FIG. 6 is a schematic cross-sectional view illustrating a comparative example of pixels included in the display device;
FIG. 7 is a schematic cross-sectional view taken along line I-I' of FIG. 6;
FIG. 8 is a schematic cross-sectional view illustrating an example of a pixel included in the display device of FIG. 1;
FIG. 9 is a schematic cross-sectional view taken along line I-I' of FIG. 8;
FIG. 10 is a schematic cross-sectional view illustrating an example of the pixel of FIG. 8;
FIGS. 11 to 17 are schematic plan views illustrating a method of manufacturing a display device; and
FIGS. 18 to 21 are schematic views of examples of an electronic device including the display device of FIG. 1.

### DETAILED DESCRIPTION OF THE EMBODIMENTS

Hereinafter, embodiments of the invention will be described in more detail with reference to the accompanying drawings. This invention may, however, be embodied in different forms and should not be construed as limited to the embodiments set forth herein. Rather, these embodiments are provided so that this disclosure will be thorough and complete, and will fully convey the scope of the invention to those skilled in the art. The same reference numerals are used for the same components in the drawings, and an overlapping description of the same components is omitted.

In the drawings, sizes, thicknesses, ratios, and dimensions of the elements may be exaggerated for ease of description and for clarity. Like numbers refer to like elements throughout.

As used herein, the singular forms, "a," "an," and "the" are intended to include the plural forms as well, unless the context clearly indicates otherwise.

In the specification and the claims, the term "and/or" is intended to include any combination of the terms "and" and "or" for the purpose of its meaning and interpretation. For example, "A and/or B" may be understood to mean any combination including "A, B, or A and B." The terms "and" and "or" may be used in the conjunctive or disjunctive sense and may be understood to be equivalent to "and/or."

For the purposes of this disclosure, the phrase "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z.

It will be understood that, although the terms first, second, etc., may be used herein to describe various elements, these elements should not be limited by these terms. These terms are only used to distinguish one element from another element. For example, a first element may be referred to as a second element, and similarly, a second element may be referred to as a first element without departing from the scope of the disclosure.

"About" or "approximately" or "substantially" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

The term "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

When an element is described as "not overlapping" or to "not overlap" another element, this may include that the elements are spaced apart from each other, offset from each other, or set aside from each other or any other suitable term as would be appreciated and understood by those of ordinary skill in the art.

The terms "face" and "facing" mean that a first element may directly or indirectly oppose a second element. In a case in which a third element intervenes between the first and second element, the first and second element may be understood as being indirectly opposed to one another, although still facing each other.

The terms "comprises," "comprising," "includes," and/or "including,", "has," "have," and/or "having," and variations thereof when used in this specification, specify the presence of stated features, integers, steps, operations, elements, components, and/or groups thereof, but do not preclude the presence or addition of one or more other features, integers, steps, operations, elements, components, and/or groups thereof.

The phrase "in plan view" means viewing the object from the top, and the phrase "in cross-sectional view" means viewing a cross-section of which the object is vertically cut from the side.

Unless otherwise defined or implied herein, all terms (including technical and scientific terms) used herein have the same meaning as commonly understood by one of ordinary skill in the art to which the disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

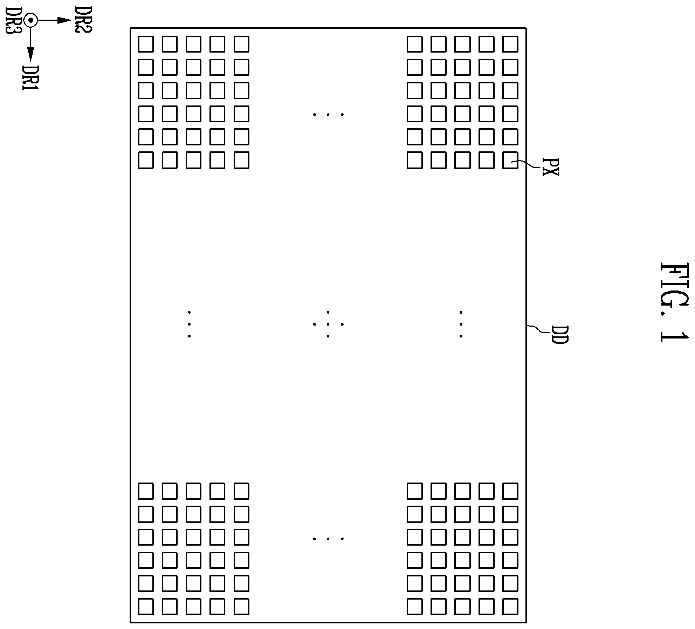

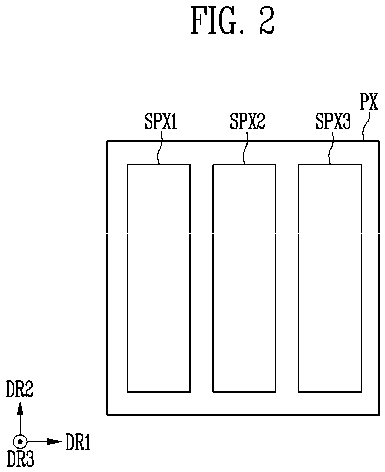

FIG. 1 is a schematic plan view illustrating a display device. FIG. 2 is a schematic cross-sectional view illustrating an example of a pixel of FIG. 1.

Referring to FIG. 1, the display device DD is a device for displaying a video or a still image. The display device DD may be used as a display screen of various products such as not only a portable electronic device such as a mobile phone, a smart phone, a tablet personal computer (PC), a smart watch, a watch phone, a mobile communication terminal, an electronic notebook, an electronic book, a portable multimedia player (PMP), a navigation device, and an ultra mobile PC (UMPC), but also a television, a notebook computer, a monitor, a billboard, and Internet of things (IOT).

A display device DD may be formed in a rectangular shape in plan view having a long side of a first direction DR1 and a short side of a second direction DR2 intersecting the first direction DR1. A corner where the long side of the first direction DR1 and the short side of the second direction DR2 meet may be formed to be rounded to have a curvature or may be formed in a right angle. A planar shape of the display device is not limited to a quadrangle, and may be formed in another shape, such as a polygon, circle, or ellipse. The display device DD may be formed to be flat, but is not limited thereto. For example, the display device DD may include a curved portion formed at left and right ends and having a constant curvature or a varying curvature. The display device DD may be flexibly formed to be crooked, curved, bent, folded, or rolled.

The display device DD may further include pixels PX, scan lines extending in the first direction DR1, and data lines extending in the second direction DR2 to display an image. The pixels PX may be arranged in a matrix shape in the first direction DR1 and the second direction DR2.

Each of the pixels PX may include sub-pixels SPX1, SPX2, and SPX3. FIG. 2 illustrates that each of the pixels PX includes three sub-pixels SPX1, SPX2, and SPX3, that is, a first sub-pixel SPX1, a second sub-pixel SPX2, and a third sub-pixel SPX3, but not limited thereto.

The first sub-pixel SPX1, the second sub-pixel SPX2, and the third sub-pixel SPX3 may be connected to at least one of the data lines and at least one scan line among the scan lines.

Each of the first sub-pixel SPX1, the second sub-pixel SPX2, and the third sub-pixel SPX3 may have a planar shape of a rectangle, a square, or a rhombus. For example, each of the first sub-pixel SPX1, the second sub-pixel SPX2, and the third sub-pixel SPX3 may have a planar shape of a rectangle having a short side of the first direction DR1 and a long side of the second direction DR2. In another implementation, each of the first sub-pixel SPX1, the second sub-pixel SPX2, and the third sub-pixel SPX3 may have a planar shape of a square or a rhombus including sides having the same length in the first direction DR1 and the second direction DR2.

The first sub-pixel SPX1, the second sub-pixel SPX2, and the third sub-pixel SPX3 may be arranged in the first direction DR1. In another implementation, any of the second sub-pixel SPX2 and the third sub-pixel SPX3 and the first sub-pixel SPX1 may be arranged in the first direction DR1, and the other of the second sub-pixel SPX2 and the third sub-pixel SPX3 and the first sub-pixel SPX1 may be arranged in the second direction DR2.

In another implementation, any of the first sub-pixel SPX1 and the third sub-pixel SPX3 and the second sub-pixel SPX2 may be arranged in the first direction DR1, and the other of the first sub-pixel SPX1 and the third sub-pixel SPX3 and the second sub-pixel SPX2 may be arranged in the second direction DR2. In another implementation, any of the first sub-pixel SPX1 and the second sub-pixel SPX2 and the third sub-pixel SPX3 may be arranged in the first direction DR1, and the other of the first sub-pixel SPX1 and the second sub-pixel SPX2 and the third sub-pixel SPX3 may be arranged in the second direction DR2.

The first sub-pixel SPX1 may emit first light, the second sub-pixel SPX2 may emit second light, and the third sub-pixel SPX3 may emit third light. The first light may be light of a red wavelength band, the second light may be light of a green wavelength band, and the third light may be light of a blue wavelength band. The red wavelength band may be a wavelength band of about 600 nm to about 750 nm, the green wavelength band may be a wavelength band of about 480 nm to about 560 nm, and the blue wavelength band may be a wavelength band of about 370 nm to about 460 nm, but are not limited thereto.

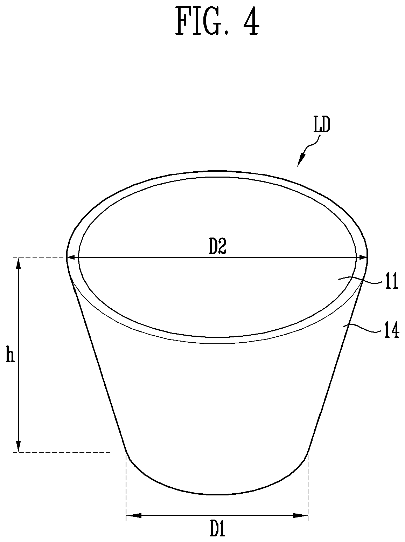

Each of the first sub-pixel SPX1, the second sub-pixel SPX2, and the third sub-pixel SPX3 may include a light emitting element LD (refer to FIG. 4) that emits light, and the light emitting element LD may include an inorganic light emitting element including an inorganic semiconductor.

The area of the first sub-pixel SPX1, the area of the second sub-pixel SPX2, and the area of the third sub-pixel SPX3 may be substantially the same, but are not limited thereto. At least one of the area of the first sub-pixel SPX1, the area of the second sub-pixel SPX2, and the area of the third sub-pixel SPX3 may be different from another area. In another implementation, any two of the area of the first sub-pixel SPX1, the area of the second sub-pixel SPX2, and the area of the third sub-pixel SPX3 may be substantially the same and the other one may be different from the two areas. In another implementation, the area of the first sub-pixel SPX1, the area of the second sub-pixel SPX2, and the area of the third sub-pixel SPX3 may be different from each other.

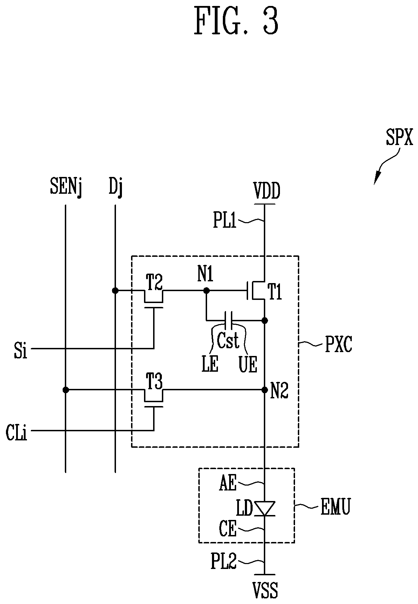

FIG. 3 is a schematic circuit diagram illustrating an example of a sub-pixel included in the pixel of FIG. 2.

The sub-pixel SPX shown in FIG. 3 may be any of the sub-pixels SPX1 to SPX3 shown in FIG. 2, and the sub-pixels SPX1 to SPX3 arranged in a display area of each display device DD may be configured substantially identically or similarly to each other.

In FIG. 3, for convenience, a sub-pixel SPX positioned in an i-th pixel row (or an i-th horizontal line) and a j-th pixel column is shown (where i and j are natural numbers).

Referring to FIG. 3, the sub-pixel SPX may include a light emitting unit EMU that generates light of a luminance corresponding to a data signal. The sub-pixel SPX may further include a pixel circuit PXC for driving the light emitting unit EMU.

The light emitting unit EMU may include a light emitting element LD connected between a first power line PL1 receiving a voltage of a first driving power VDD (or first power) and a second power line PL2 receiving a voltage of second driving power VSS (or second power). For example, the light emitting unit EMU may include the light emitting element LD including a first electrode AE connected to the first driving power VDD via the pixel circuit PXC and the first power line PL1 and a second electrode CE connected to the second driving power VSS via the second power line PL2. The first electrode AE may be an anode, and the second electrode CE may be a cathode.

In FIG. 3, one light emitting element LD is disposed between the first electrode AE and the second electrode CE, but the disclosure is not limited thereto. For example, light emitting elements LD connected in parallel between the first electrode AE and the second electrode CE may be included.

The first driving power VDD and the second driving power VSS may have different potentials. At this time, a potential difference between the first power VDD and the second power VSS may be set to be higher than or equal to a threshold voltage of the light emitting element LD during an emission period of the sub pixel SPX.

In case that the sub-pixel SPX is positioned in the i-th pixel row and the j-th pixel column in the display area of the display device DD, the pixel circuit PXC of the sub-pixel SPX (or the sub-pixel) may be electrically connected to an i-th scan line Si and a j-th data line Dj. The pixel circuit PXC may be electrically connected to an i-th control line CLi and a j-th sensing line SENj.

The above-described pixel circuit PXC may include first to third transistors T1 to T3 and a storage capacitor Cst.

The first transistor T1 may be a driving transistor for controlling a driving current applied to the light emitting element LD, and may be electrically connected between the first driving power VDD and the light emitting element LD. Specifically, a first terminal of the first transistor T1 may be electrically connected to the first driving power VDD through the first power line PL1, a second terminal of the first transistor T1 may be electrically connected to a second node N2, and a gate electrode of the first transistor T1 may be electrically connected to a first node N1. The first transistor T1 may control an amount of the driving current applied from the first driving power VDD to the light emitting element LD through the second node N2 according to a voltage applied to the first node N1. The first terminal of the first transistor T1 may be a drain electrode, and the second terminal of the first transistor T1 may be a source electrode, but the disclosure is not limited thereto. The first terminal may be a source electrode and the second terminal may be a drain electrode.

The second transistor T2 may be a switching transistor that selects the sub-pixel SPX in response to a scan signal and activates the sub-pixel SPX, and may be electrically connected between the data line Dj (for example, the j-th data line) and the first node N1. A first terminal of the second transistor T2 may be electrically connected to the data line Dj, a second terminal of the second transistor T2 may be connected to the first node N1 (or the gate electrode of the first transistor T1), and a gate electrode of the second transistor T2 may be electrically connected to the scan line Si (or the i-th scan line). The first terminal and the second terminal of the second transistor T2 may be different terminals, and for example, in case that the first terminal is a drain electrode, a second terminal may be a source electrode.

The second transistor T2 may be turned on in case that a scan signal of a gate-on voltage (for example, a high level voltage) is supplied from the scan line Si, to electrically connect the data line Dj and the first node N1. The first node N1 may be a point where the second terminal of the second transistor T2 and the gate electrode of the first transistor T1 are connected, and the second transistor T2 may transfer a data signal to the gate electrode of the first transistor T1.

The third transistor T3 may obtain a sensing signal through the sensing line SENj by electrically connecting the first transistor T1 to the sensing line SENj (for example, the j-th sensing line), and detect a characteristics of the sub-pixel SPX including a threshold voltage of the first transistor T1 by using the sensing signal. Information on the characteristic of the sub-pixel SPX may be used to convert image data so that a characteristic deviation between the sub-pixels SPX may be compensated. A second terminal of the third transistor T3 may be electrically connected to the second terminal of the first transistor T1, a first terminal of the third transistor T3 may be electrically connected to the sensing line SENj, and a gate electrode of the third transistor T3 may be electrically connected to the control line CLi (for example, the i-th control line). The first terminal may be a drain electrode, and the second terminal may be a source electrode.

The third transistor T3 may be an initialization transistor capable of initializing the second node N2, and may be turned on in case that a sensing control signal is supplied from the control line CLi to transfer a voltage of initialization power to the second node N2. Accordingly, the storage capacitor Cst electrically connected to the second node N2 may be initialized.

The storage capacitor Cst may include a lower electrode LE (or a first storage electrode) and an upper electrode UE (or a second storage electrode). The lower electrode LE may be electrically connected to the first node N1 and the upper electrode UE may be electrically connected to the second node N2. The storage capacitor Cst may charge a data voltage corresponding to the data signal supplied to the first node N1 during a frame period. Accordingly, the storage capacitor Cst may store a voltage corresponding to a difference between a voltage of the gate electrode of the first transistor T1 and a voltage of the second node N2.

In FIG. 3, circuit in which all of the first to third transistors T1, T2, and T3 are N-type transistors is disclosed, but the disclosure is not limited thereto. For example, at least one of the above-described first to third transistors T1 to T3 may be changed to a P-type transistor. A structure of the pixel circuit PXC may be variously modified and implemented.

In the following, for convenience of description, a width direction (an X-axis direction, or a horizontal direction) in plan view is indicated as the first direction DR1, a height direction (a Y-axis direction, or a vertical direction) in plan view is indicated as the second direction DR2, and a vertical direction on a cross section is indicated as a third direction DR3.

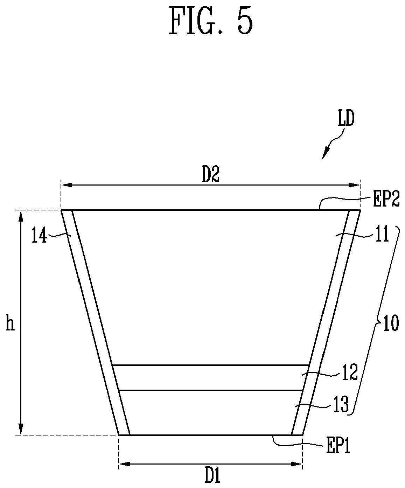

FIG. 4 is a schematic perspective view illustrating the light emitting element included in the sub-pixel of FIG. 2. FIG. 5 is a schematic cross-sectional view illustrating an example of the light emitting element of FIG. 4.

Referring to FIGS. 4 and 5, the light emitting element LD may include a first semiconductor layer 11, an active layer 12, and a second semiconductor layer 13. For example, the light emitting element LD may be configured as a light emitting stack 10 in which the first semiconductor layer 11, the active layer 12, and the second semiconductor layer 13 are stacked on each other. The light emitting element LD may further include a combination electrode layer (not shown), and the combination electrode layer may be stacked on a surface of the first semiconductor layer 11 or a surface of the second semiconductor layer 13.

A lower surface of the light emitting element LD may be referred to as a first end EP1 and an upper surface of the light emitting element LD may be referred to as a second end EP2 along a height h direction.

The light emitting element LD may have a columnar shape in which a diameter D1 of the first end EP1 and a diameter D2 of the second end EP2 are different from each other. For example, the light emitting element LD may have a columnar shape in which the diameter D1 of the first end EP1 is less than the diameter D2 of the second end EP2. For example, the light emitting element LD may have an elliptical column shape with a diameter increasing toward an upper portion along the height h direction. The light emitting element LD may have a columnar shape in which the diameter D1 of the first end EP1 is greater than the diameter D2 of the second end EP2. For example, the light emitting element LD may have an elliptical column shape with a diameter decreasing toward the upper portion along the height h direction.

The shape of the first end part EP1 and the second end part EP2 of the light emitting element LD may be implemented as a polygon such as a rectangle, a square, an equilateral triangle, or a regular pentagon. The light emitting element LD may have a truncated pyramid shape in which an area of an upper surface and an area of a lower surface are different from each other.

The light emitting element LD may have a size of a nano-scale to a micro-scale. However, the size of the light emitting element LD is not limited thereto, and the size of the light emitting element LD may be variously changed according to a design condition of various devices (for example, a display device or the like) using a light emitting device using the light emitting element LD as a light source.

The first semiconductor layer 11 may be a semiconductor layer of a first conductivity (or type). For example, the first semiconductor layer 11 may include at least one n-type semiconductor. For example, the first semiconductor layer 11 may include a semiconductor material among InAlGaN, GaN, AlGaN, InGaN, AIN, and InN, and may include an n-type semiconductor layer doped with a first conductive dopant such as Si, Ge, and/or Sn. However, a material configuring the first semiconductor layer 11 is not limited thereto, and the first semiconductor layer 11 may be configured of various other materials.

The active layer 12 may be disposed on a surface of the first semiconductor layer 11. The active layer 12 may be formed in a single or multi-quantum well structure. A clad layer (not shown) doped with a conductive dopant may be formed on and/or under the active layer 12. For example, the clad layer may be formed of AlGaN or InAlGaN. A material of AlGaN, InAlGaN, or the like may be used to form the active layer 12, and other various materials may configure the active layer 12.

The second semiconductor layer 13 may be disposed on a surface of the active layer 12. The second semiconductor layer 13 may include a semiconductor layer of a conductivity (or type) different from that of the first semiconductor layer 11. For example, the second semiconductor layer 13 may include at least one p-type semiconductor layer. For example, the second semiconductor layer 13 may include at least one semiconductor material among InAlGaN, GaN, AlGaN, InGaN, AIN, and InN, and may include a p-type semiconductor layer doped with a second conductive dopant such as Mg, Zn, Ca, Sr, and/or Ba. However, a material configuring the second semiconductor layer 13 is not limited thereto, and other various materials may configure the second semiconductor layer 13.

The light emitting element LD may further include an electrode (not shown) disposed on the first semiconductor layer 11 and/or under the second semiconductor layer 13, in addition to the first semiconductor layer 11, the active layer 12, and the second semiconductor layer 13.

The electrode may be an ohmic contact electrode, but the disclosure is not limited thereto. The electrode may be a schottky contact electrode. The electrode may include a conductive material. For example, the electrode may include an opaque metal using chromium (Cr), titanium (Ti), aluminum (Al), gold (Au), nickel (Ni), and an oxide or an alloy thereof alone or in combination. However, the disclosure is not limited thereto. The electrode may include a transparent conductive oxide such as indium tin oxide (ITO), indium zinc oxide (IZO), zinc oxide (ZnO), indium gallium zinc oxide (IGZO), and/or indium tin zinc oxide (ITZO).

The light emitting element LD may further include an insulating layer 14. The insulating layer 14 may be omitted or may be provided to cover only a portion of the light emitting stack 10.

The insulating layer 14 may prevent an electrical short that may occur in case that the active layer 12 contacts a conductive material other than the first and second semiconductor layers 11 and 13. The insulating layer 14 may minimize a surface defect of the light emitting element LD to improve a lifespan and a light emission efficiency of the light emitting element LD. In case that the light emitting elements LD are closely disposed, the insulating layer 14 may prevent an unwanted short that may occur between the light emitting elements LD. Whether the insulating layer 14 is provided or not is not limited as long as a short between the active layer 12 and an external conductive material may be prevented from occurring.

The light emitting element LD may further include a reflective member (not shown) surrounding an outer circumferential surface of the insulating layer 14. The reflective member may include a reflective material to concentrate light emitted from the light emitting element LD in a specific area while allowing the light to proceed in an image display direction.

In the case that a voltage higher than or equal to the threshold voltage is applied to the lower surface (or the first end EP1) and the upper surface (or the second end EP2) of the light emitting element LD, an electron-hole pair is combined in the active layer 12 and thus the light emitting element LD may emit light.

A light emitting device including the light emitting element LD described above may be used in various types of devices requiring a light source, including a display device. For example, the light emitting elements LD may be disposed in each sub-pixel SPX of the display device DD described above, and the light emitting elements LD may be used as a light source of each sub-pixel SPX. However, an application field of the light emitting element LD is not limited to the above-described example. For example, the light emitting element LD may be used in other types of devices requiring a light source, such as a lighting device.

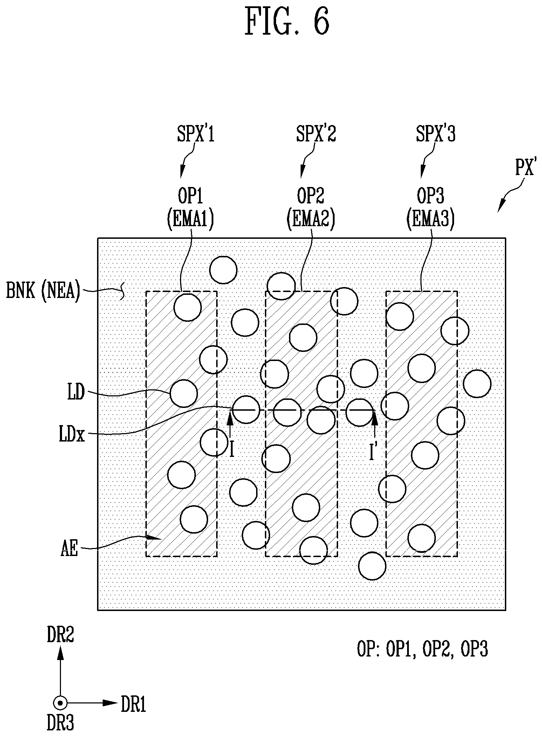

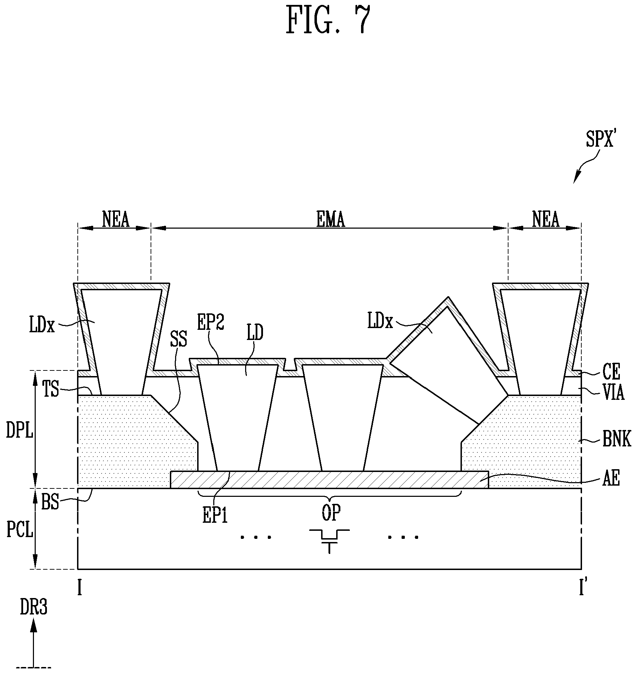

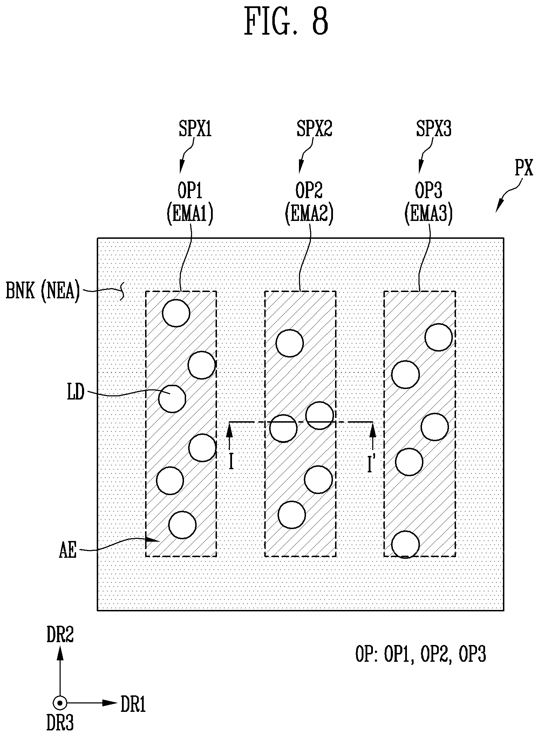

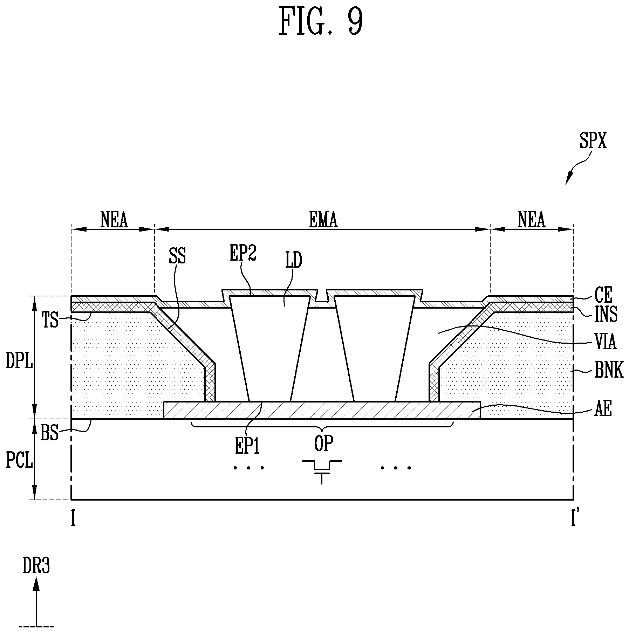

Hereinafter, FIGS. 6 and 7 are diagrams illustrating a pixel PX' including light emitting elements LD disposed an emission area EMA and non-light emitting elements LDx disposed on a non-emission area NEA, as comparative examples. FIGS. 8 and 9 are diagrams illustrating a pixel PX including the light emitting elements LD disposed only on the emission area EMA as an embodiment of the invention.

FIG. 6 is a schematic cross-sectional view illustrating a comparative example of pixels included in the display device. FIG. 7 is a schematic cross-sectional view taken along line I-I' of FIG. 6.

Referring to FIGS. 6 and 7, the pixel PX' may include the emission area EMA and the non-emission area NEA.

The emission area EMA may be an area including the light emitting element LD, where light is emitted. The non-emission area NEA may include the non-emission element LDx and may be disposed to surround the emission area EMA.

A bank BNK may partition first to third sub-pixels SPX'1 to SPX'3 (SPX' in FIG. 7). First to third emission areas EMA1 to EMA3 may correspond to an opening OP defined by the bank BNK. The non-emission area NEA may be an area substantially corresponding to the bank BNK. In a plan view, the bank BNK may surround the first to third emission areas EMA1 to EMA3.

The bank BNK may be disposed on the first electrode AE and expose the first electrode AE through the opening OP.

Referring to FIGS. 6 and 7, during a manufacturing process of the display device, the light emitting element LD and the non-light emitting element LDx may be entirely disposed on a display element unit DPL. The light emitting element LD and the non-light emitting element LDx may be vertically disposed on the display element unit DPL. The light emitting element LD may be disposed on the first electrode AE, and the non-light emitting element LDx may be disposed outside the emission area EMA. For example, the non-light emitting element LDx may be disposed on a second surface TS of the bank BNK (or an outer surface SS of the bank BNK). The non-light emitting element LDx may overlap the bank BNK in a plan view.

The light emitting element LD may directly contact the first electrode AE. The first end EP1 of the light emitting element LD may be electrically connected to the first electrode AE. Since the non-light emitting element LDx is disposed to overlap the bank BNK, the non-light emitting element LDx may not contact the first electrode AE.

Referring to FIG. 7, the second electrode CE may entirely cover the light emitting element LD and the non-light emitting elements LDx. The light emitting element LD may emit light based on an electrical signal provided from the first electrode AE and the second electrode CE. For example, the light emitting element LD is a light emitting element in a normal state (light emitting state). Since the first end EP1 of the non-light emitting element LDx contacts the bank BNK, the non-light emitting element LDx may not receive an electrical signal from the first electrode AE. For example, the non-light emitting element LDx is a light emitting element in a defective state (non-light emitting state) in which a contact defect occurs.

A step difference may be formed according to a height difference between positions where the light emitting element LD and the non-light emitting element LDx are disposed in the second electrode CE. In an example, as the light emitting element LD is disposed in the opening OP of the bank BNK, and the non-light emitting element LDx is disposed on the second surface TS of the bank BNK (or the outer surface SS of the bank BNK), a step difference covering the light emitting element LD and the non-light emitting element LDx may be formed in the second electrode CE.

The second electrode CE may be disconnected due to the step difference formed on the second electrode CE, and thus a contact defect between the light emitting elements LD may be caused. Accordingly, light emission efficiency of the pixel PX' is reduced, and thus securing reliability is difficult.

A planarization process for flatly disposing the second electrode CE entirely disposed on the light emitting elements LD may be desired during the manufacturing process, but as the non-light emitting element LDx is disposed on the second surface TS of the bank BNK (or the outer surface SS of the bank BNK), performing an optimized planarization process is difficult.

FIG. 8 is a schematic cross-sectional view illustrating a pixel included in the display device of FIG. 1. FIG. 9 is a schematic cross-sectional view taken along line I-I' of FIG. 8.

Referring to FIGS. 8 and 9, the pixel PX may include the emission area EMA and the non-emission area NEA. The emission area EMA may be an emission area including the light emitting element LD, where light is emitted. The non-emission area NEA may be disposed to surround the emission area EMA.

The pixel PX may include first to third sub-pixels SPX1 to SPX3. The first sub-pixel SPX1 may include a first emission area EMA1, the second sub-pixel SPX2 may include a second emission area EMA2, and a third sub-pixel SPX3 may include a third emission area EMA3.

Referring to FIG. 8, the bank BNK may partition first to third sub-pixels SPX1 to SPX3. In an example, the first to third emission areas EMA1 to EMA3 may correspond to the opening OP defined by the bank BNK. In an example, the first emission area EMA1 may correspond to a first opening OP1, the second emission area EMA2 may correspond to a second opening OP2, and the third emission area EMA3 may correspond to a third opening OP3.

The non-emission area NEA may be an area substantially corresponding to the bank BNK. In a plan view, the bank BNK may surround the first to third emission areas EMA1 to EMA3.

In accordance with the invention, the bank BNK exposes the first electrode AE through the opening OP. The opening OP formed in the bank BNK is a space for receiving the light emitting elements LD. For example, during a manufacturing process of the display device, the light emitting elements LD may be provided in the opening OP, and the light emitting elements LD may be disposed on the first electrode AE.

Referring to FIGS. 8 and 9, the first electrode AE is disposed under the bank BNK. The first electrode AE may be disposed in an area corresponding to the emission area EMA (or the opening OP). The first electrode AE is exposed through the opening OP. In an example, a portion of the first electrode AE may overlap the non-emission area NEA, and a remaining portion of the first electrode AE may overlap the emission area EMA.

The bank BNK may be protruded in the third direction DR3 on a pixel circuit unit PCL. The bank BNK may include a first surface BS, a second surface TS facing the first surface BS, and an outer surface SS surrounding the first surface BS and the second surface TS. The first surface BS may be a surface that contacts the first electrode AE and the pixel circuit unit PCL. The second surface TS may be a surface spaced apart from the first surface BS in the third direction DR3. The outer surface SS may be a surface connecting the first surface BS and the second surface TS.

The insulating layer INS covers the bank BNK. In accordance with the invention, the insulating layer INS covers the second surface TS and the outer surface SS of the bank BNK. In FIG. 9, the insulating layer INS covers the second surface TS and the outer surface SS of the bank BNK, but the insulating layer INS may cover only the second surface TS.

The insulating layer INS may include a non-photosensitive insulating material. The insulating layer INS may be an insulating layer disposed to remove the light emitting elements disposed on the bank BNK in a manufacturing process. The non-photosensitive insulating material may include at least one of silicon oxide (SiOₓ), silicon nitride (SiNₓ), and silicon oxynitride (SiOₓN_{y}).

The light emitting elements LD do not overlap the bank BNK in a plan view. In accordance with the invention, the light emitting elements LD are not disposed on the second surface TS of the bank BNK (or the outer surface SS of the bank BNK). The light emitting elements LD do not overlap the insulating layer INS in a plan view. The light emitting elements LD are disposed only on the first electrode AE.

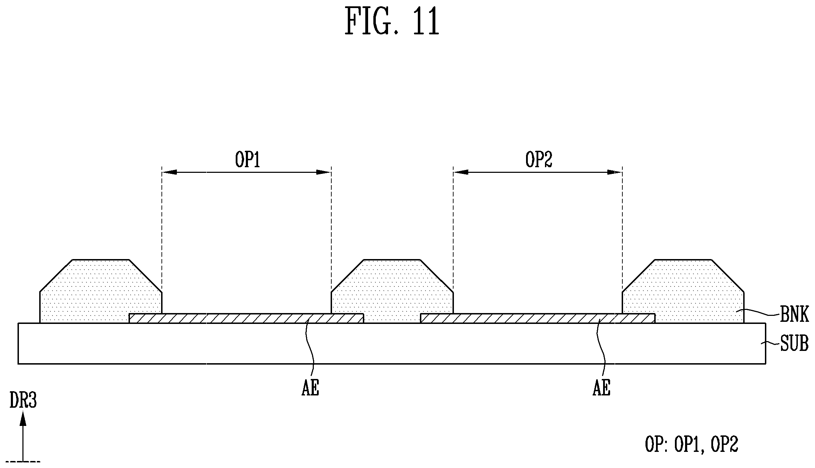

The light emitting elements disposed on the second surface TS (and/or outer surface SS) of the bank BNK in a process of providing the light emitting elements during the manufacturing process of the display device (for example, the non-light emitting elements LDx of FIG. 6) are removed. A process of removing the light emitting elements disposed on the bank BNK is described later with reference to FIGS. 11 to 17.

Referring to FIG. 9, the pixel PX may include the pixel circuit unit PCL and the display element unit DPL. The pixel circuit unit PCL may be a layer including a pixel circuit for driving the light emitting elements LD. The pixel circuit unit PCL may include metal layers for forming pixel circuits and insulating layers disposed between the metal layers. The pixel circuits may include a thin layer transistor. The pixel circuits may further include a storage capacitor. The pixel circuits may be electrically connected to the light emitting elements LD to provide an electrical signal for the light emitting elements LD to emit light.

The display element unit DPL may be disposed on the pixel circuit unit PCL. The display element unit DPL may include the bank BNK, the first electrode AE, the light emitting element LD, and the second electrode CE. The display element unit DPL may further include a via layer VIA.

The first electrode AE may be disposed on the pixel circuit unit PCL. The first electrode AE may be disposed under the light emitting element LD and electrically connected to the light emitting element LD. For example, the first electrode AE may be electrically connected to the light emitting element LD through the first end EP1 adjacent to the second semiconductor layer of the light emitting element LD.

The first electrode AE may be electrically connected to the pixel circuit (for example, a driving transistor) formed in the pixel circuit unit PCL, and thus may receive the electrical signal (for example, a driving signal as an anode signal) for driving the light emitting elements LD. The second electrode CE may be electrically connected to a power line to supply a voltage of the power line to the light emitting element LD. The second electrode CE may be a cathode electrode (common electrode) and may receive a cathode signal.

The electrical signal for the light emitting elements LD to emit light may be applied to the first electrode AE, and the electrical signal may be applied to each light emitting element LD through an electrical contact surface between the light emitting elements LD and the first electrode AE.

The second electrode CE may be disposed on the light emitting elements LD and electrically connected to the light emitting elements LD. For example, the second electrode CE may be electrically connected to the light emitting elements LD through the second end EP2 adjacent to the first semiconductor layer (for example, the first semiconductor layer 11 of FIG. 4) of the light emitting element LD.

The first electrode AE may be a pixel electrode for the light emitting elements LD, and the second electrode CE may be a common electrode for the light emitting elements LD. The first electrode AE and the second electrode CE may be disposed to face each other with the light emitting elements LD interposed therebetween.

The first electrode AE may be an anode electrode for the light emitting element LD, and the second electrode CE may be a common electrode (or a cathode electrode) for the light emitting element LD. The first electrode AE and the second electrode CE may include a conductive material. For example, the first electrode AE may include a conductive material having a reflective property, and the second electrode CE may include a transparent conductive material, but the disclosure is not necessarily limited thereto.

The pixel PX may further include the via layer VIA (or a planarization layer). The via layer VIA may fill the opening OP. The via layer VIA may fill between the light emitting elements LD. The via layer VIA may expose the second end EP2 of the light emitting element LD. The via layer VIA may be disposed according to an optimal process condition for planarization of the second electrode CE in consideration of a height of the light emitting element LD and the bank BNK. The via layer VIA may substantially planarize a surface of the second electrode CE. For example, the via layer VIA may minimize formation of a step difference in the second electrode CE covering an upper portion of the light emitting elements LD.

The via layer VIA may include an organic material such as acrylic resin, epoxy resin, phenolic resin, polyamide resin, polyimide resin, polyester resin, polyphenylenesulfide resin, and/or benzocyclobutene (BCB). However, the disclosure is not necessarily limited thereto, and the via layer VIA may include various types of inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ)), hafnium oxide (HfOₓ), and/or titanium oxide (TiOₓ).

The second electrode CE may be entirely coated on the bank BNK, the via layer VIA, and the light emitting elements LD. The second electrode CE may cover the insulating layer INS, the via layer VIA, and the light emitting elements LD disposed on the second surface TS of the bank BNK.

As the light emitting element LD is disposed only on the emission area EMA (and the first electrode AE), the pixel PX may prevent (or reduce) formation of a step difference in the second electrode CE by the light emitting element disposed on the bank BNK. Accordingly, since the second electrode CE may be prevented from being disconnected in case that the second electrode CE is not flatly disposed due to a step formed on the second electrode CE, the pixel PX (or the display device) according to an embodiment may prevent (or reduce) a contact defect occurring between the light emitting element LD and the second electrode CE. As a result, the pixel PX (or the display device) with improved reliability may be provided.

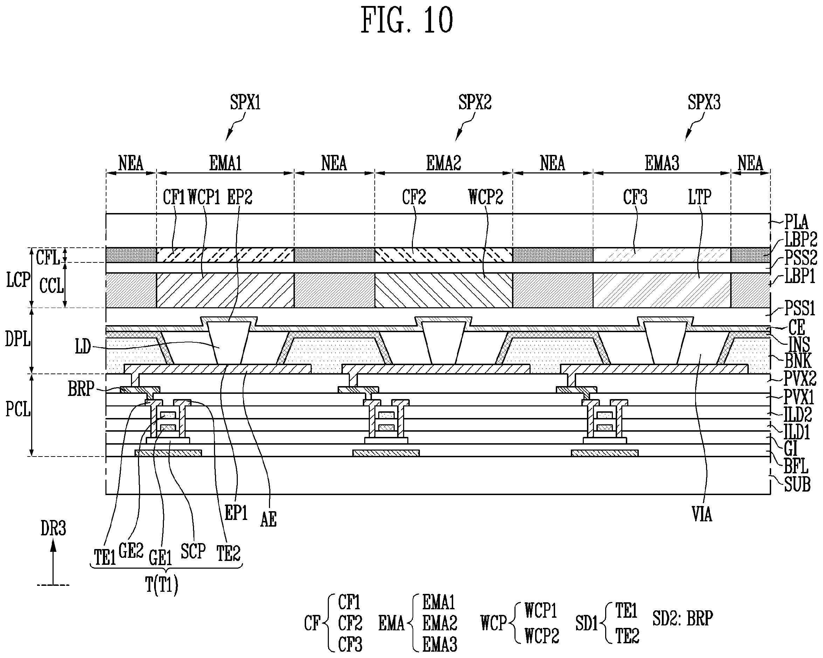

FIG. 10 is a schematic cross-sectional view illustrating an example of the pixel of FIG. 8.

Referring to FIG. 10, the pixel PX may include a substrate SUB, and a pixel circuit unit PCL, a display element unit DPL, a light control unit LCP (or a light control layer), and the like sequentially disposed on the substrate SUB.

Each of the first to third sub-pixels SPX1 to SPX3 may include the first to third emission areas EMA1 to EMA3, and the non-emission area NEA may be positioned between the first to third emission areas EMA1 to EMA3.

For convenience of description, one light emitting element LD is disposed in the first to third emission areas EMA1 to EMA3, but the disclosure is not limited thereto, and multiple light emitting elements LD may be disposed.

The pixel circuit unit PCL may be provided on a surface of the substrate SUB. The pixel circuit unit PCL may include circuit elements configuring each of the first to third sub-pixels SPX1 to SPX3. For example, transistors T and a capacitor Cst configuring the pixel circuit PXC of the corresponding sub-pixel may be formed in each of the first to third sub-pixels SPX1 to SPX3 of the pixel circuit unit PCL.

In FIG. 10, as an example of circuit elements that may be provided in the pixel circuit unit PCL of the first to third sub-pixels SPX1 to SPX3, any one transistor T (for example, the first transistor T1) connected to each light emitting element LD is shown.

The pixel circuit unit PCL may include various signal lines, power lines, and/or pads connected to the first to third sub-pixels SPX1 to SPX3. The pixel circuit unit PCL may include conductive layers configuring the various signal lines, power lines, and/or pads. The pixel circuit unit PCL may further include insulating layers respectively disposed between the conductive layers.

A buffer layer BFL may be disposed on the substrate SUB. The buffer layer BFL may prevent diffusion of an impurity into the circuit elements. The buffer layer BFL may be configured as a single layer, but may also be configured as multiple layers of at least double or more layers. In case that the buffer layer BFL is formed as multiple layers, each layer may be formed of the same material or different materials.

A semiconductor pattern SCP may be disposed on the buffer layer BFL. For example, each semiconductor pattern SCP may include a first area contacting a first transistor electrode TE1, a second area contacting a second transistor electrode TE2, and a channel area positioned between the first and second areas. One of the first and second areas may be a source area and the other may be a drain area.

The semiconductor pattern SCP may be formed of polysilicon, amorphous silicon, an oxide semiconductor, and/or the like. The channel area of the semiconductor pattern SCP may be an intrinsic semiconductor as a semiconductor pattern which is not doped with an impurity, and each of the first and second areas of the semiconductor pattern SCP may be a semiconductor doped with an impurity.

A gate insulating layer GI may be disposed on the buffer layer BFL and the semiconductor pattern SCP. For example, the gate insulating layer GI may be disposed between the semiconductor pattern SCP and a first gate electrode GE1. The gate insulating layer GI may be configured as a single layer or multiple layers, and may include various types of inorganic materials including, e.g., silicon oxide (SiOx), silicon nitride (SiNx), silicon oxynitride (SiOxNy), aluminum nitride (AINx), aluminum oxide (AlOx), zirconium oxide (ZrOx), hafnium oxide (HfOx), and/or titanium oxide (TiOx).

The first gate electrode GE1 may be disposed on the gate insulating layer GI. The first gate electrode GE1 may be disposed to overlap the semiconductor pattern SCP on the gate insulating layer GI in the third direction DR3.

A first interlayer insulating layer ILD1 may be disposed on the gate insulating layer GI. For example, the first interlayer insulating layer ILD1 may be disposed between the first gate electrode GE1 and the first and second transistor electrodes TE1 and TE2.

The first interlayer insulating layer ILD1 may be configured as a single layer or multiple layers and may include the inorganic material.

A second gate electrode GE2 may be disposed on the first interlayer insulating layer ILD1. The second gate electrode GE2 may overlap the first gate electrode GE1 in the third direction DR3 with the first interlayer insulating layer ILD1 interposed therebetween.

A second interlayer insulating layer ILD2 may be disposed on the first interlayer insulating layer ILD1. For example, the second interlayer insulating layer ILD2 may be disposed between the second gate electrode GE2 and the first and second transistor electrodes TE1 and TE2.

The second interlayer insulating layer ILD2 may be configured as a single layer or multiple layers and may include the inorganic material.

A first source-drain conductive layer SD1 may be disposed on the second interlayer insulating layer ILD2. The first source-drain conductive layer SD1 may include the first and second transistor electrodes TE1 and TE2 of the transistor T. The first and second transistor electrodes TE1 and TE2 may be disposed to overlap the semiconductor pattern SCP in the third direction DR3. The first and second transistor electrodes TE1 and TE2 may be electrically connected to the semiconductor pattern SCP. For example, the first transistor electrode TE1 may be electrically connected to the first area of the semiconductor pattern SCP through a contact hole passing through the second interlayer insulating layer ILD2, the first interlayer insulating layer ILD1, and/or the gate insulating layer GI. The second transistor electrode TE2 may be electrically connected to the second area of the semiconductor pattern SCP through a contact hole passing through the second interlayer insulating layer ILD2, the first interlayer insulating layer ILD1, and/or the gate insulating layer GI. One of the first and second transistor electrodes TE1 and TE2 may be a source electrode and the other may be a drain electrode.

The first source-drain conductive layer SD1 may be formed as a single layer or multiple layers formed of, e.g., at least one of aluminum (Al), molybdenum (Mo), chromium (Cr), gold (Au), titanium (Ti), nickel (Ni), neodymium (Nd), indium tin oxide (ITO), and an alloy thereof.

A first protective layer PVX1 may be disposed on the first source-drain conductive layer SD1. The first protective layer PVX1 may be configured as a single layer or multiple layers. For example, the first protective layer PVX1 may include an organic material such as acrylates resin, epoxy resin, phenolic resin, polyamides resin, polyimide resin, polyesters resin, polyphenylenesulfides resin, and/or benzocyclobutene (BCB). However, the disclosure is not necessarily limited thereto, and the first protective layer PVX1 may include various types of inorganic materials including silicon oxide (SiOx), silicon nitride (SiNx), silicon oxynitride (SiOxNy), aluminum nitride (AlNx), aluminum oxide (AlOx), zirconium oxide (ZrOx), hafnium oxide (HfOx), and/or titanium oxide (TiOx).

A second source-drain conductive layer SD2 may be disposed on the first protective layer PVX1. The second source-drain conductive layer SD2 may include a bridge pattern BRP. The bridge pattern BRP may serve to electrically connect the transistor T and the first electrode AE provided to the light emitting unit EMU of each of the first to third sub-pixels SPX1 to SPX3. For example, the bridge pattern BRP may be electrically connected to the first transistor electrode TE1 of the transistor T through a contact hole passing through the first protective layer PVX1. The first electrode AE of the corresponding sub-pixel SPX may be electrically connected to the bridge pattern BRP through a contact hole passing through a second protective layer PVX2 to be described later.

The second source-drain conductive layer SD2 may be formed as a single layer or multiple layers formed of, e.g., at least one of aluminum (Al), molybdenum (Mo), chromium (Cr), gold (Au), titanium (Ti), nickel (Ni), neodymium (Nd), indium tin oxide (ITO), and an alloy thereof alone or in combination.

The second protective layer PVX2 may be disposed on the second source-drain conductive layer SD2. The second protective layer PVX2 may be formed of an organic material to planarize a lower step difference. However, the disclosure is not necessarily limited thereto, and the second protective layer PVX2 may include various types of inorganic materials.

The display element unit DPL may be disposed on the second protective layer PVX2. The display element unit DPL may include first electrodes AE, a bank BNK, light emitting elements LD, a via layer VIA, a second electrode CE, and/or a first passivation layer PSS1.

For example, the first electrodes AE of each of the sub-pixels SPX1 to SPX3 may be disposed on the pixel circuit unit PCL to be positioned in each of the emission areas EMA1 to EMA3. For example, the first electrode AE of the first sub-pixel SPX1 may be disposed on the pixel circuit part PCL to be positioned in the first emission area EMA1, the first electrode AE of the second sub-pixel SPX2 may be disposed on the pixel circuit unit PCL to be positioned in the second emission area EMA2, and the first electrode AE of the third sub-pixel SPX3 may be disposed on the circuit unit PCL to be positioned in the third emission area EMA3. Each first electrode AE may be an anode electrode provided to corresponding sub-pixels SPX1 to SPX3. The first electrodes AE of the first to third sub-pixels SPX1 to SPX3 may be separated from each other.

Each first electrode AE may be electrically connected to at least one circuit element configuring the pixel circuit PXC of the corresponding sub-pixels SPX1 to SPX3. For example, the first electrode AE of the first sub-pixel SPX1 may be electrically connected to at least one circuit element configuring the pixel circuit PXC of the first sub-pixel SPX1 (for example, the transistor T of the first sub-pixel SPX1). The first electrode AE of the second sub-pixel SPX2 may be electrically connected to at least one circuit element configuring the pixel circuit PXC of the second sub-pixel SPX2 (for example, the transistor T of the second sub-pixel SPX2). The first electrode AE of the third sub-pixel SPX3 may be electrically connected to at least one circuit element configuring the pixel circuit PXC of the third sub-pixel SPX3 (for example, the transistor T of the third sub-pixel SPX3).

The first electrodes AE may be disposed on the second protective layer PVX2. The first electrodes AE may be electrically connected to each of the bridge patterns BRP through respective contact holes.

Each first electrode AE may be disposed under the light emitting elements LD provided in the corresponding sub-pixels SPX1 to SPX3 and may be electrically connected to the light emitting elements LD. For example, each first electrode AE may contact the first end EP1 of the light emitting element LD provided in the corresponding sub-pixels SPX1 to SPX3 to be electrically connected to the first end EP1 of the light emitting element LD.

Each first electrode AE may transfer an electrical signal provided through the pixel circuit PXC or the like of the corresponding sub-pixels SPX1 to SPX3 to the first end EP1 of the light emitting element LD. For example, the first electrode AE may transfer the voltage of the first power VDD supplied through each pixel circuit PXC to the first end EP1 of the light emitting element LD provided to the corresponding sub-pixels SPX1 to SPX3.

Each first electrode AE may include a bonding metal bonded to each light emitting element LD. The first electrode AE may have conductivity by including at least one conductive material, and a configuration material thereof is not particularly limited. For example, the first electrode AE may include at least one metal among molybdenum (Mo), aluminum (Al), platinum (Pt), palladium (Pd), silver (Ag), magnesium (Mg), gold (Au), nickel (Ni), neodymium (Nd), iridium (Ir), chromium (Cr), titanium (Ti), tantalum (Ta), tungsten (W), and copper (Cu), or other conductive materials.

The first electrode AE may include a reflective conductive material. For example, the first electrode AE may be formed of a metal layer including at least one of reflective metals including a metal having a high reflectance in a visible light wavelength band, for example, aluminum (Al), gold (Au), and silver (Ag). Accordingly, light efficiency of the sub-pixels SPX1 to SPX3 may be increased.

The bank BNK may be disposed on the first electrode AE and the second protective layer PVX2. The bank BNK may be disposed between the first to third emission areas EMA1 to EMA3 or at a boundary between the first to third emission areas EMA1 to EMA3. For example, the bank BNK may overlap the non-emission area NEA. The bank BNK may include an opening (for example, the opening OP of FIG. 8) exposing the first electrode AE. The opening of the bank BNK may partially expose the first electrode AE. An edge of the first electrode AE may be covered by the bank BNK. The bank BNK may include at least one light blocking and/or reflective material. For example, the bank BNK may include at least one black matrix material, a color filter material of a specific color, and/or the like, and may include various other materials.

The light emitting element LD may be disposed on the first electrode AE. The light emitting element LD may be disposed on the first electrode AE exposed by the opening of the bank BNK. The first end EP1 of the light emitting element LD may be disposed on the first electrode AE and electrically connected to the first electrode AE. Since the light emitting element LD is described in detail with reference to FIGS. 8 and 9, a redundant discussion is omitted.

An insulating layer INS may be disposed on the bank BNK. The insulating layer INS may cover the bank BNK protruded in the third direction DR3. The light emitting elements LD may not overlap the insulating layer INS.

The via layer VIA may be disposed on the first electrode AE and the light emitting element LD. The via layer VIA may be disposed between the light emitting elements LD of each of the sub-pixels SPX1 to SPX3. For example, the via layer VIA may be disposed to surround the light emitting elements LD.

The via layer VIA may include an organic material such as acrylates resin, epoxy resin, phenolic resin, polyamides resin, polyimide resin, polyesters resin, polyphenylenesulfides resin, and/or benzocyclobutene (BCB), but is not necessarily limited thereto.

The second electrode CE may be disposed on the via layer VIA. For example, the first to third sub-pixels SPX1 to SPX3 may share one second electrode CE. The second electrode CE may be disposed on the second end EP2 of the light emitting elements LD and electrically connected to the second end EP2 of the light emitting elements LD.

The second electrode CE may have conductivity by including at least one conductive material. The second electrode CE may include a transparent conductive material. For example, the second electrode CE may include at least one material of a conductive oxide such as indium tin oxide (ITO), indium zinc oxide (IZO), zinc oxide (ZnO or ZnO2), indium gallium zinc oxide (IGZO), and indium tin zinc oxide (ITZO), and a conductive polymer such as poly(3,4-ethylenedioxythiophene) (PEDOT), and/or may include another transparent conductive material. The second electrode CE may be substantially transparent. Accordingly, light emission efficiency (for example, a front surface light emission rate) of light generated from each light emitting element LD may be increased. The second electrode CE may be configured as a single layer or multiple layers, and a shape, a structure and/or a size thereof are/is not particularly limited.

The first passivation layer PSS1 may be disposed on the second electrode CE. The first passivation layer PSS1 may include at least one insulating material and may be configured as a single layer or multiple layers. For example, the first passivation layer PSS1 may include an organic insulating material and may planarize a surface of the display element unit DPL.

The light control unit LCP may be disposed on the display element unit DPL. The light control unit LCP may be disposed on a path through which the light generated from the light emitting elements LD is emitted.

The light control unit LCP may include a color conversion layer CCL and a color filter layer CFL. For example, light emitting elements LD emitting light of a third color (for example, blue) may be disposed in the first to third sub-pixels SPX1 to SPX3, a first wavelength conversion pattern WCP1 and a second wavelength conversion pattern WCP2 respectively including first color conversion particles and second color conversion particles may be provided on the first to second sub-pixels SPX1 to SPX2. Accordingly, a full-color image may be displayed in the display area. However, the disclosure is not necessarily limited thereto, and the first to third sub-pixels SPX1 to SPX3 may include light emitting elements LD emitting light of different colors. For example, the respective first to third sub-pixels SPX1 to SPX3 may include red, green, and blue light emitting elements LD.

The color conversion layer CCL may be disposed on the first passivation layer PSS1. The color conversion layer CCL may include a wavelength conversion pattern WCP, a light transmission pattern LTP, a first light blocking pattern LBP1, and a second passivation layer PSS2. The wavelength conversion pattern WCP may include the first wavelength conversion pattern WCP1 and the second wavelength conversion pattern WCP2.

The first wavelength conversion pattern WCP1 may be disposed to overlap the first emission area EMA1 of the first sub-pixel SPX1. For example, the first wavelength conversion pattern WCP1 may be disposed in an opening of the first light blocking pattern LBP1.

The second wavelength conversion pattern WCP2 may be disposed to overlap the second emission area EMA2 of the second sub-pixel SPX2. For example, the second wavelength conversion pattern WCP2 may be disposed in the opening of the first light blocking pattern LBP1.

The light transmission pattern LTP may be disposed to overlap the third emission area EMA3 of the third sub-pixel SPX3. For example, the light transmission pattern LTP may be disposed in the opening of the first light blocking pattern LBP1.

The first light blocking pattern LBP1 may include the openings overlapping each of the first to third emission areas EMA1 to EMA3. The first wavelength conversion pattern WCP1 may be disposed in the opening of the first light blocking pattern LBP1 overlapping the first emission area EMA1. The second wavelength conversion pattern WCP2 may be disposed in the opening of the first light blocking pattern LBP1 overlapping the second emission area EMA2. The light transmission pattern LTP may be disposed in the opening of the first light blocking pattern LBP1 overlapping the third emission area EMA3.

The first wavelength conversion pattern WCP1 may include first color conversion particles that convert the third color light emitted from the light emitting element LD provided in the first emission area EMA1 into first color light. For example, in case that the light emitting element LD provided in the first emission area EMA1 is a blue light emitting element emitting blue light and the first sub-pixel SPX1 is a red pixel, the first wavelength conversion pattern WCP1 may include a first quantum dot (for example, a red quantum dot) that converts the blue light emitted from the blue light emitting element into red light. A type of the first color conversion particles and a color and/or a wavelength of light converted in the first wavelength conversion pattern WCP1 may be variously changed.

The second wavelength conversion pattern WCP2 may include second color conversion particles that convert the third color light emitted from the light emitting element LD provided in the second emission area EMA2 into second color light. For example, in case that the light emitting element LD provided in the second emission area EMA2 is a blue light emitting element emitting blue light and the second sub-pixel SPX2 is a green pixel, the second wavelength conversion pattern WCP2 may include a second quantum dot (for example, a green quantum dot) that converts the blue light emitted from the blue light emitting element into green light. A type of second color conversion particles and a color and/or a wavelength of light converted in the second wavelength conversion pattern WCP2 may be variously changed.

The light transmission pattern LTP may be provided to efficiently emit the third color light emitted from the light emitting element LD provided in the third emission area EMA3. For example, in case that the light emitting element LD provided in the third emission area EMA3 is a blue light emitting element emitting blue light and the third sub-pixel SPX3 is a blue pixel, the light transmission pattern LTP may include at least one type of light scattering particles (for example, silica or other light scattering particles) for increasing light efficiency of the third sub-pixel SPX3 by scattering the blue light emitted from the blue light emitting element.

It may not be that the light scattering particles are disposed only in the third emission area EMA3. For example, the light scattering particles may also be selectively included in the first wavelength conversion pattern WCP1 and/or the second wavelength conversion pattern WCP2.

The first light blocking pattern LBP1 may overlap the non-emission area NEA. The first light blocking pattern LBP1 may be formed in a mesh shape pattern that surrounds each of the emission areas EMA in plan view and includes openings corresponding to the emission areas EMA. The first light blocking pattern LBP1 may surround the wavelength conversion patterns WCP and the light transmission patterns LTP provided in each of the emission areas EMA.

The first light blocking pattern LBP1 may include at least one light blocking material capable of blocking transmission of light and absorbing light. For example, the first light blocking pattern LBP1 may include an organic material including at least one of graphite, carbon black, black pigment, and black dye, at least one material among metals including chromium (Cr), and/or various other light blocking materials.

The second passivation layer PSS2 may be disposed on the wavelength conversion patterns WCP and the light transmission patterns LTP. The second passivation layer PSS2 may include at least one insulating material and may be configured as a single layer or multiple layers. For example, the second passivation layer PSS2 may include an organic insulating material and may substantially planarize a surface of the color conversion layer CCL.

The color filter layer CFL may be disposed on the color conversion layer CCL. A first color filter CF1 may be positioned on the light emitting element LD of the first sub-pixel SPX1 and selectively transmit light of a first color. For example, the first color filter CF1 may include a color filter material of the first color that transmits the light of the first color and blocks light of a second color and a third color.

The second color filter CF2 may be positioned on the light emitting element LD of the second sub-pixel SPX2 and selectively transmit the light of the second color. For example, the second color filter CF2 may include a second color filter material that transmits the light of the second color and blocks the light of the first color and the third color.

The third color filter CF3 may be positioned on the light emitting element LD of the third sub-pixel SPX3 and selectively transmit the light of the third color. For example, the third color filter CF3 may include a color filter material of the third color that transmits the light of the third color and blocks transmission of the light of the first color and the second color.

A second light blocking pattern LBP2 may surround the first to third emission areas EMA1 to EMA3. The second light blocking pattern LBP2 may include openings overlapping the first to third emission areas EMA1 to EMA3. The openings of the second light blocking pattern LBP2 may respectively correspond to the first to third emission areas EMA1 to EMA3. For example, the opening of the second light blocking pattern LBP2 may have the same or similar shape as a planar shape of the emission areas EMA (refer to FIG. 8). A width of the first direction DR1 of the opening of the second blocking pattern LBP2 may be different from a width of the second direction DR2 of the opening of the second blocking pattern LBP2. For example, the width of the first direction DR1 of the opening of the second light blocking pattern LBP2 may be less than the width of the second direction DR2.

The first color filter CF1 may be disposed to overlap the first emission area EMA1 of the first sub-pixel SPX1. For example, the first color filter CF1 may be disposed in the opening of the second light blocking pattern LBP2. The second color filter CF2 may be disposed to overlap the second emission area EMA2 of the second sub-pixel SPX2. For example, the second color filter CF2 may be disposed in the opening of the second light blocking pattern LBP2. The third color filter CF3 may be disposed to overlap the third emission area EMA3 of the third sub-pixel SPX3. For example, the third color filter CF3 may be disposed in the opening of the second light blocking pattern LBP2.

The second light blocking pattern LBP2 may include at least one light blocking material capable of blocking transmission of light and absorbing light. For example, the second light blocking pattern LBP2 may include an organic material including at least one of graphite, carbon black, black pigment, and black dye, at least one material among metals including chromium (Cr), and/or various other light blocking materials.

A planarization layer PLA may be included on the color filter layer CFL. The planarization layer PLA may cover the color filters CF. The planarization layer PLA may substantially planarize a step difference due to a lower member including the color filter layer CFL. The planarization layer PLA may include an organic insulating material. For example, the planarization layer PLA may include an organic material such as acrylates resin, epoxy resin, phenolic resin, polyamides resin, polyimides resin, polyesters resin, polyphenylenesulfides resin, and/or benzocyclobutene (BCB), but is not necessarily limited thereto.

FIGS. 11 to 17 are schematic plan views illustrating a method of manufacturing a display device.

Referring to FIG. 11, the first electrode AE and the bank BNK may be sequentially formed on the substrate SUB in the third direction DR3. In accordance with the invention, the first electrode AE is formed on the substrate SUB. The bank BNK is formed to overlap the edge of the first electrode AE and the substrate SUB. The first electrode AE is exposed through the first and second openings OP1 and OP2.

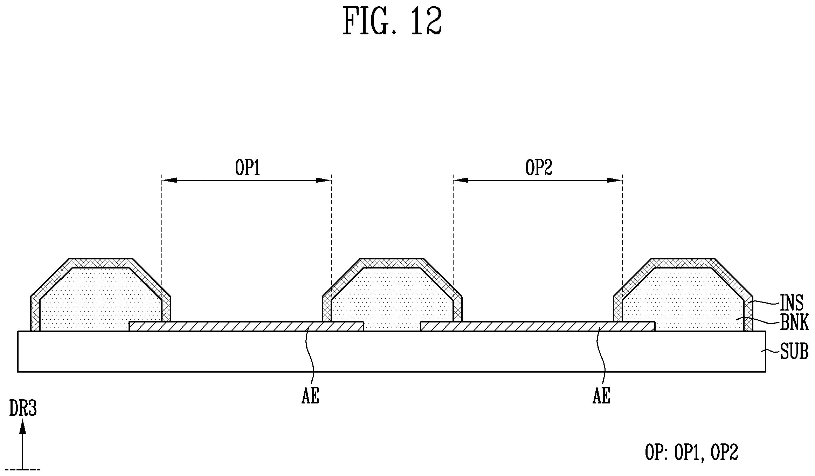

Referring to FIG. 12, in accordance with the invention, the insulating layer INS is formed to cover the bank BNK. The insulating layer INS is formed to cover the bank BNK protruded in the third direction DR3. The insulating layer INS may be formed of a non-photosensitive insulating material.

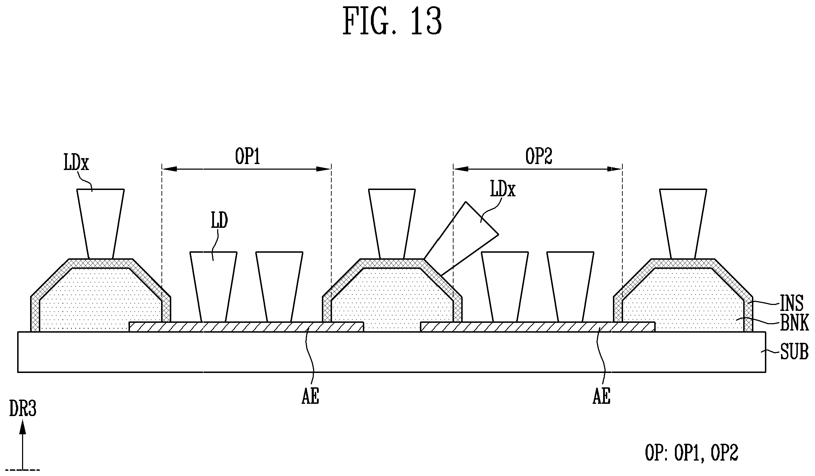

Referring to FIG. 13, in accordance with the invention, the light emitting elements LD and the non-light emitting elements LDx are formed on the substrate SUB. The light emitting elements LD and the non-light emitting elements LDx may be transferred on the bank BNK. Transferring the light emitting element LD and the non-light emitting element LDx may be performed according to at least one of a transfer method using a stamp, a transfer method using a laser, a transfer method using electrostatic force, a transfer method using magnetic force and electromagnetic force, and a transfer method using an adhesive.

The light emitting elements LD and the non-light emitting elements LDx may be collectively transferred to sub-pixel areas. The light emitting elements LD and the non-light emitting elements LDx may be formed on the first electrode AE and/or the bank BNK, and may be collectively referred to as the light emitting elements. The non-light emitting elements LDx (e.g., a first subset of the light emitting elements) may be defective light emitting elements formed on the second surface TS of the bank BNK (or the side surface SS of the bank BNK). The light emitting elements LD (e.g., a second subset of the light emitting elements) may be formed on the first electrode AE and may be normal light emitting elements. Since a non-light emitting element LDx corresponds to a configuration that disrupts planarization of the second electrode CE to be described later, the non-light emitting element LDx are removed.

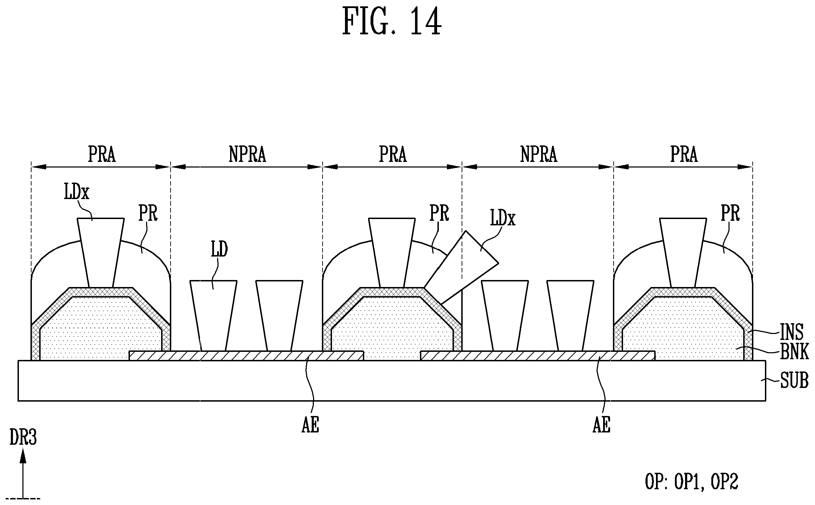

Referring to FIG. 14, a photoresist pattern PR may be formed on the bank BNK using a mask (not shown). In an example, the photoresist pattern PR may be formed on the insulating layer INS covering the bank BNK. The mask may include an area PRA where the photoresist pattern PR is formed and an area NPRA where the photoresist pattern PR is not formed. In an example, the area NPRA where the photoresist pattern PR is not formed may overlap the openings (for example, the openings OP1 and OP2 of FIG. 13) of the bank BNK.

The photoresist pattern PR may surround the non-light emitting element LDx. In an example, the photoresist pattern PR may surround one area of the non-light emitting element LDx.

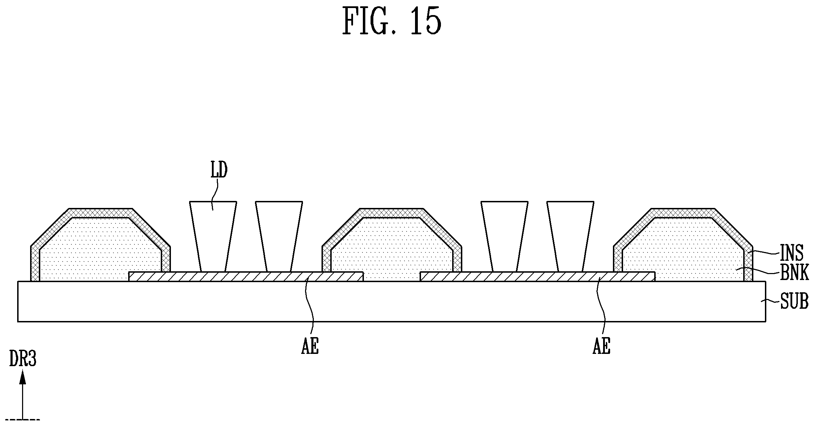

Referring to FIG. 15, the non-light emitting element LDx may be removed by a lift-off process. As the non-light emitting element LDx is removed, only the light emitting element LD may be disposed on the substrate SUB. After the non-light emitting element LDx is removed, the light emitting element LD may be bonded to the first electrode AE. In case that the light emitting element LD is transferred onto the first electrode AE and bonded to the first electrode AE, the light emitting element LD may be electrically connected to the first electrode AE. As a bonding method, an anisotropic conductive film (AFC) bonding method, a laser assist bonding (LAB) method using laser, an ultrasonic bonding method, a bump-ball surface mounting method (ball grid array (BGA), a pressure and heat bonding method (thermo compression (TC) bonding), and/or the like may be used. In an example, the insulating layer INS may not be removed in a process in which the non-light emitting element LDx is removed, and may be a protective layer for preventing the bank BNK from being damaged (or destroyed).

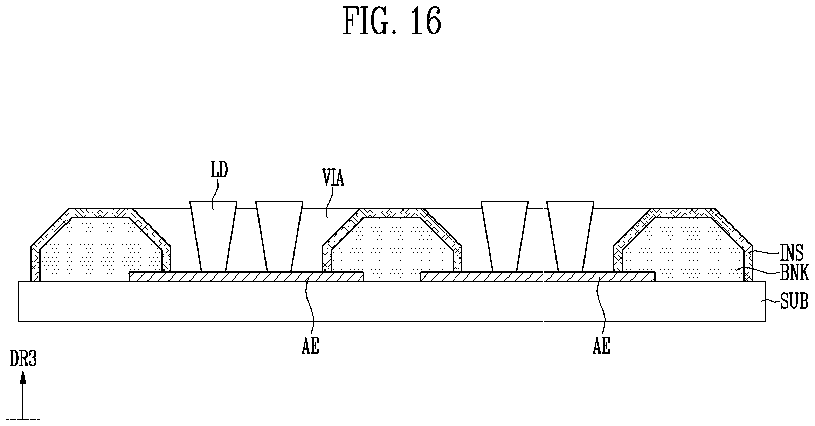

Referring to FIG. 16, the via layer VIA is formed to fill between the light emitting elements LD. In accordance with the invention, the via layer VIA may fill the openings OP1 and OP2 of the bank BNK. The via layer VIA may enable the second electrode CE to be described later to be formed substantially flat.

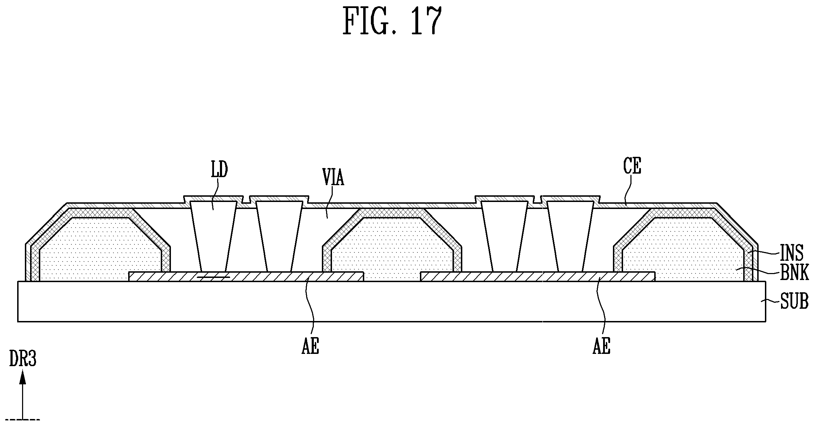

Referring to FIG. 17, a second electrode CE is formed on the light emitting elements LD. In accordance with the invention, the second electrode CE is disposed on the light emitting elements LD, the via layer VIA, and the insulating layer INS. The first passivation layer PSS1, the color conversion layer CCL, and the color filter layer CFL may be sequentially disposed on the second electrode CE, but configurations are not limited thereto, and any one configuration may be omitted according to a process condition.

The display device and the method of manufacturing the same according to the embodiments of the invention may prevent a step difference from occurring in the common electrode disposed on the light emitting element as the light emitting element is disposed only in the emission area. Therefore, a phenomenon in which the common electrode is disconnected may be solved, and thus a display device with improved reliability may be provided.

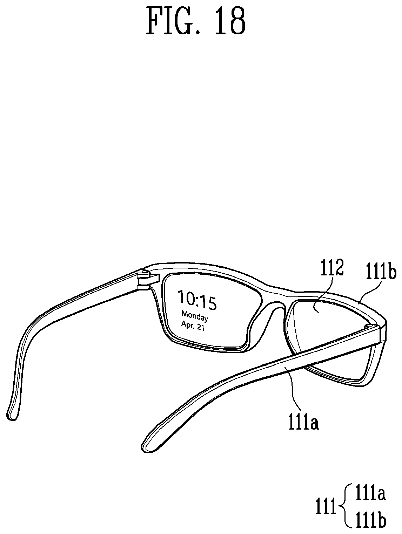

FIGS. 18 to 21 are schematic views of examples of an electronic device including the display device of FIG. 1.

Referring to FIG. 18, the display device according to the above-described embodiments may be applied to smart glasses. The smart glasses may include a frame 111 and a lens unit 112. The smart glasses may be a wearable electronic device that may be worn on a user's face, and may have a structure in which a portion of the frame 111 is folded or unfolded. For example, the smart glasses may be a wearable device for augmented reality (AR).

The frame 111 may include a housing 111b supporting the lens unit 112 and a leg unit 111a for wearing by a user. The leg unit 111a may be connected to the housing 111b by a hinge and folded or unfolded.

A battery, a touch pad, a microphone, a camera, and/or the like may be embedded in the frame 111. A projector for outputting light, a processor for controlling a light signal, and/or the like may be embedded in the frame 111.

The lens unit 112 may be an optical member that transmits light or reflects light. The lens unit 112 may include glass, transparent synthetic resin, and/or the like.

The display device according to the above-described embodiments may be applied to the lens unit 112. For example, the user may recognize an image displayed by an optical signal transmitted from the projector of the frame 111 through the lens unit 112. For example, the user may recognize information such as time and date displayed on the lens unit 112.

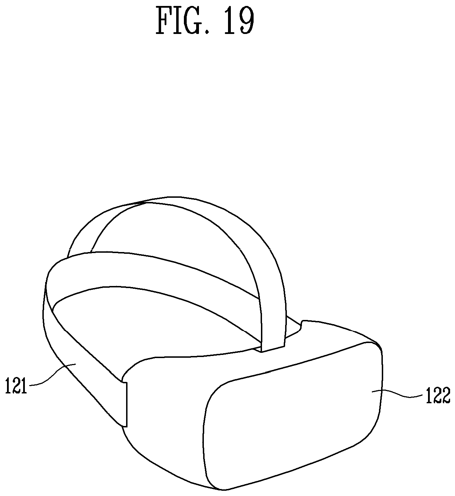

Referring to FIG. 19, the display device according to the above-described embodiments may be applied to a head mounted display (HMD). The HMD may include a head mounted band 121 and a display receiving case 122. For example, the HMD may be a wearable electronic device worn on a user's head.

The head mounted band 121 may be connected to the display receiving case 122 to fix the display receiving case 122. As shown in FIG. 19, the head mounted band 121 may include a horizontal band and a vertical band to fix the HMD to the user's head, the horizontal band may surround a side portion of the user's head, and the vertical band may be provided to surround an upper portion of the user's head. However, the disclosure is not necessarily limited thereto, and the head mounted band 121 may be implemented in a form of an eyeglass frame or a helmet.

The display receiving case 122 may receive the display device and may include at least one lens. At least one lens may provide an image to the user. For example, the display device according to the above-described embodiments may be applied to a left eye lens and/or a right eye lens implemented in the display receiving case 122.

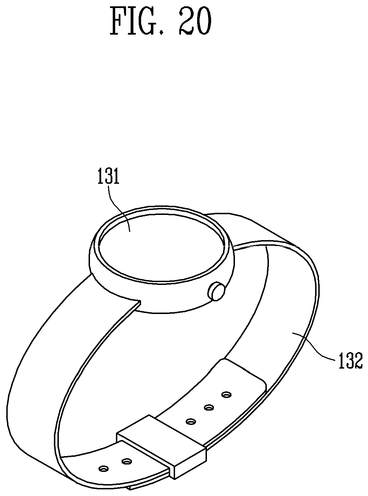

Referring to FIG. 20, the display device according to the above-described embodiments may be applied to a smart watch. The smart watch may include a display unit 131 and a strap unit 132. The smart watch may be a wearable electronic device, and the strap unit 132 may be mounted on a user's wrist. The display device according to the above-described embodiments may be applied to the display unit 131. For example, the display unit 131 may provide image data including information such as time and date.

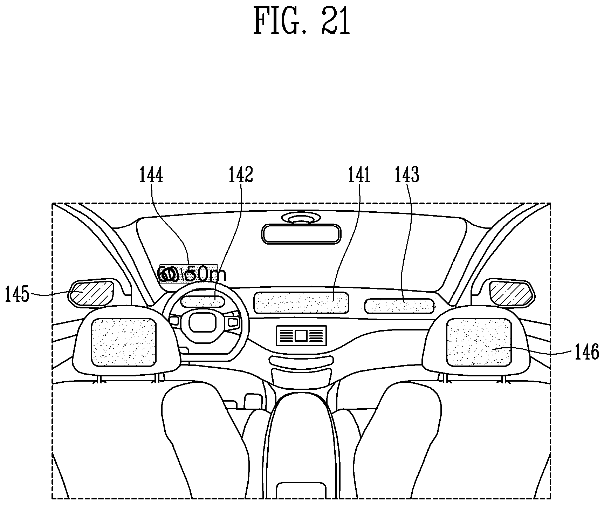

Referring to FIG. 21, the display device according to the above-described embodiments may be applied to an automotive display. For example, the automotive display may refer to an electronic device provided inside and outside a vehicle to provide image data.

For example, the display device according to the above-described embodiments may be applied to at least one of an infotainment panel 141, a cluster 142, a co-driver display 143, a head-up display 144, a side mirror display 145, and a rear seat display 146.

Although the above has been described with reference to embodiments of the invention, those skilled in the art will understand that the embodiments may be variously modified and changed without departing from the scope of the invention, as defined by the claims.

## Claims

1. A display device, comprising:
a first electrode (AE) disposed on a substrate (SUB);
a bank (BNK) disposed on the substrate (SUB) and covering an edge portion of the first electrode (AE), the bank (BNK) including an opening (OP) exposing a portion of the first electrode (AE);
light emitting elements (LD) disposed on the first electrode (AE);
an insulating layer (INS) disposed on the bank (BNK) to overlap the bank (BNK) in a plan view;
a via layer (VIA) filling the opening (OP); and
a second electrode (CE) disposed on the insulating layer (INS), the via layer (VIA), and the light emitting elements (LD),
wherein the bank (BNK) includes:
a first surface (BS) contacting the substrate (SUB);
a second surface (TS) opposite the first surface (BS); and
an outer surface (SS) extending from the first surface (BS) to the second surface (TS),
wherein the insulating layer (INS) is disposed on the second surface (TS) of the bank (BNK) and the outer surface (SS) of the bank (BNK), the light emitting elements (LD) are not disposed on the insulating layer (INS), and the insulating layer (INS) entirely covers the second surface (TS) of the bank (BNK) and the outer surface (SS) of the bank (BNK).

2. The display device according to claim 1, wherein the second electrode (CE) directly contacts the insulating layer (INS) disposed on the second surface of the bank (BNK).

3. The display device according to claim 1, wherein the via layer (VIA) is not disposed on the second surface of the bank (BNK).

4. The display device according to claim 1 or 3, wherein the via layer (VIA) contacts the insulating layer (INS) overlapping the outer surface of the bank (BNK).

5. The display device according to any one of claims 1 to 4, wherein
each of the light emitting elements (LD) includes a first end and a second end opposite the first end,
the first end directly contacts the first electrode (AE), and
the second end directly contacts the second electrode (CE).

6. The display device according to claim 5, wherein
each of the light emitting elements (LD) includes a second semiconductor layer, an active layer, and a first semiconductor layer different from the second semiconductor layer, which are sequentially stacked on each other in a third direction,
the first end of each of the light emitting elements (LD) is adjacent to the second semiconductor layer of each of the light emitting elements (LD), and
the second end of each of the light emitting elements (LD) is adjacent to the first semiconductor layer of each of the light emitting elements (LD),
optionally wherein
the first semiconductor layer of each of the light emitting elements (LD) is an n-type semiconductor layer, and
the second semiconductor layer of each of the light emitting elements (LD) is a p-type semiconductor layer.

7. The display device according to any one of the preceding claims, further comprising:
a light control layer on the second electrode (CE),
wherein the light control layer comprises:
a first light blocking pattern partitioning an emission area and a non-emission area;
a wavelength conversion pattern disposed in the first light blocking pattern, and overlapping the emission area in a plan view;
a second light blocking pattern disposed on the first light blocking pattern; and
color filters disposed on the wavelength conversion pattern.

8. A method of manufacturing a display device, the method comprising:
forming a first electrode (AE) and a bank (BNK) including an opening (OP) exposing a portion of the first electrode (AE) on a substrate (SUB),
wherein the bank (BNK) covers an edge portion of the first electrode (AE),
wherein the bank (BNK) includes:
a first surface (BS) contacting the substrate (SUB),
a second surface (TS) opposite the first surface (BS), and
an outer surface (SS) extending from the first surface (BS) to the second surface (TS);
forming an insulating layer (INS) on the second surface (TS) of the bank (BNK) and the outer surface (SS) of the bank (BNK);
forming light emitting elements (LD) on the substrate (SUB);
removing a first subset of the light emitting elements (LD), the first subset of the light emitting elements (LD) having been formed on the insulating layer (INS);
forming a via layer (VIA) to fill the opening (OP); and
forming a second electrode (CE) on the insulating layer (INS), the via layer (VIA), and a second subset of the light emitting elements (LD), the second subset of the light emitting elements (LD) remaining on the first electrode (AE),
wherein the insulating layer (INS) entirely covers the second surface (TS) of the bank (BNK) and the outer surface (SS) of the bank (BNK).

9. The method according to claim 8, wherein the removing of the first subset of the light emitting elements (LD) comprises:
forming a photoresist pattern (PR) to overlap the insulating layer (INS) and a portion of the first subset of the light emitting elements (LD) in a plan view; and
removing the first subset of the light emitting elements (LD), wherein the photoresist pattern (PR) does not overlap the second subset of the light emitting elements (LD) in a plan view.

## Patentansprüche

1. Anzeigevorrichtung, umfassend:
eine erste Elektrode (AE), die auf einem Substrat (SUB) angeordnet ist;
eine Bank (BNK), die auf dem Substrat (SUB) angeordnet ist und einen Kantenabschnitt der ersten Elektrode (AE) bedeckt, wobei die Bank (BNK) eine Öffnung (OP) beinhaltet, die einen Abschnitt der ersten Elektrode (AE) freigibt;
lichtemittierende Elemente (LD), die auf der ersten Elektrode (AE) angeordnet sind;
eine Isolierschicht (INS), die auf der Bank (BNK) angeordnet ist, um die Bank (BNK) in einer Draufsicht zu überlappen;
eine Durchkontaktierungsschicht (VIA), welche die Öffnung (OP) füllt; und
eine zweite Elektrode (CE), die auf der Isolierschicht (INS), der Durchkontaktierungsschicht (VIA) und den lichtemittierenden Elementen (LD) angeordnet ist,
wobei die Bank (BNK) Folgendes beinhaltet:
eine erste Oberfläche (BS), die das Substrat (SUB) kontaktiert;
eine zweite Oberfläche (TS) gegenüber der ersten Oberfläche (BS); und
eine Außenoberfläche (SS), die sich von der ersten Oberfläche (BS) zu der zweiten Oberfläche (TS) erstreckt,
wobei die Isolierschicht (INS) auf der zweiten Oberfläche (TS) der Bank (BNK) und der Außenoberfläche (SS) der Bank (BNK) angeordnet ist,
die lichtemittierenden Elemente (LD) nicht auf der Isolierschicht (INS) angeordnet sind, und
die Isolierschicht (INS) die zweite Oberfläche (TS) der Bank (BNK) und die Außenoberfläche (SS) der Bank (BNK) vollständig bedeckt.

2. Anzeigevorrichtung nach Anspruch 1, wobei die zweite Elektrode (CE) die Isolierschicht (INS), die auf der zweiten Oberfläche der Bank (BNK) angeordnet ist, direkt kontaktiert.

3. Anzeigevorrichtung nach Anspruch 1, wobei die Durchkontaktierungsschicht (VIA) nicht auf der zweiten Oberfläche der Bank (BNK) angeordnet ist.

4. Anzeigevorrichtung nach Anspruch 1 oder 3, wobei die Durchkontaktierungsschicht (VIA) die Isolierschicht (INS), welche die Außenoberfläche der Bank (BNK) überlappt, kontaktiert.

5. Anzeigevorrichtung nach einem der Ansprüche 1 bis 4, wobei
jedes der lichtemittierenden Elemente (LD) ein erstes Ende und ein zweites Ende gegenüber dem ersten Ende beinhaltet,
das erste Ende die erste Elektrode (AE) direkt kontaktiert, und
das zweite Ende die zweite Elektrode (CE) direkt kontaktiert.

6. Anzeigevorrichtung nach Anspruch 5, wobei
jedes der lichtemittierenden Elemente (LD) eine zweite Halbleiterschicht, eine aktive Schicht und eine erste Halbleiterschicht, die sich von der zweiten Halbleiterschicht unterscheidet, die sequentiell in einer dritten Richtung aufeinander gestapelt sind, beinhaltet,
das erste Ende von jedem der lichtemittierenden Elemente (LD) benachbart zu der zweiten Halbleiterschicht von jedem der lichtemittierenden Elemente (LD) ist, und
das zweite Ende von jedem der lichtemittierenden Elemente (LD) benachbart zu der ersten Halbleiterschicht von jedem der lichtemittierenden Elemente (LD) ist,
wobei optional
die erste Halbleiterschicht von jedem der lichtemittierenden Elemente (LD) eine n-Typ-Halbleiterschicht ist, und
die zweite Halbleiterschicht von jedem der lichtemittierenden Elemente (LD) eine p-Typ-Halbleiterschicht ist.

7. Anzeigevorrichtung nach einem der vorhergehenden Ansprüche, ferner umfassend:
eine Lichtsteuerschicht auf der zweiten Elektrode (CE),
wobei die Lichtsteuerschicht Folgendes umfasst:
ein erstes Lichtblockiermuster, das einen Emissionsbereich und einen Nichtemissionsbereich trennt;
ein Wellenlängenumwandlungsmuster, das in dem ersten Lichtblockiermuster angeordnet ist und den Emissionsbereich in einer Draufsicht überlappt;
ein zweites Lichtblockiermuster, das auf dem ersten Lichtblockiermuster angeordnet ist; und
Farbfilter, die auf dem Wellenlängenumwandlungsmuster angeordnet sind.

8. Verfahren zum Herstellen einer Anzeigevorrichtung, wobei das Verfahren Folgendes umfasst:
Bilden einer ersten Elektrode (AE) und einer Bank (BNK), die eine Öffnung (OP) beinhaltet, die einen Abschnitt der ersten Elektrode (AE) auf einem Substrat (SUB) freigibt,
wobei die Bank (BNK) einen Kantenabschnitt der ersten Elektrode (AE) bedeckt,
wobei die Bank (BNK) Folgendes beinhaltet:
eine erste Oberfläche (BS), die das Substrat (SUB) kontaktiert,
eine zweite Oberfläche (TS) gegenüber der ersten Oberfläche (BS), und
eine Außenoberfläche (SS), die sich von der ersten Oberfläche (BS) zu der zweiten Oberfläche (TS) erstreckt;
Bilden einer Isolierschicht (INS) auf der zweiten Oberfläche (TS) der Bank (BNK) und der Außenoberfläche (SS) der Bank (BNK);
Bilden von lichtemittierenden Elementen (LD) auf dem Substrat (SUB);
Entfernen eines ersten Teilsatzes der lichtemittierenden Elemente (LD), wobei der erste Teilsatz der lichtemittierenden Elemente (LD) auf der Isolierschicht (INS) gebildet worden ist;
Bilden einer Durchkontaktierungsschicht (VIA), um die Öffnung (OP) zu füllen; und
Bilden einer zweiten Elektrode (CE) auf der Isolierschicht (INS), der Durchkontaktierungsschicht (VIA) und einem zweiten Teilsatz der lichtemittierenden Elemente (LD), wobei der zweite Teilsatz der lichtemittierenden Elemente (LD) auf der ersten Elektrode (AE) bleibt, wobei
die Isolierschicht (INS) die zweite Oberfläche (TS) der Bank (BNK) und die Außenoberfläche (SS) der Bank (BNK) vollständig bedeckt.

9. Verfahren nach Anspruch 8, wobei das Entfernen des ersten Teilsatzes der lichtemittierenden Elemente (LD) Folgendes umfasst:
Bilden eines Fotolackmusters (PR), um die Isolierschicht (INS) und einen Abschnitt des ersten Teilsatzes der lichtemittierenden Elemente (LD) in einer Draufsicht zu überlappen; und
Entfernen des ersten Teilsatzes der lichtemittierenden Elemente (LD), wobei das Fotolackmuster (PR) den zweiten Teilsatz der lichtemittierenden Elemente (LD) in einer Draufsicht nicht überlappt.

## Revendications

1. Dispositif d'affichage, comprenant :
une première électrode (AE) disposée sur un substrat (SUB) ;
un muret (BNK) disposé sur le substrat (SUB) et recouvrant une portion de bord de la première électrode (AE), le muret (BNK) comprenant une ouverture (OP) exposant une portion de la première électrode (AE) ;
des éléments électroluminescents (LD) disposés sur la première électrode (AE) ;
une couche isolante (INS) disposée sur le muret (BNK) pour chevaucher le muret (BNK) dans une vue en plan ;
une couche de vias (VIA) remplissant l'ouverture (OP) ; et
une seconde électrode (CE) disposée sur la couche isolante (INS), la couche de vias (VIA) et les éléments électroluminescents (LD),
dans lequel le muret (BNK) comprend :
une première surface (BS) en contact avec le substrat (SUB) ;
une seconde surface (TS) opposée à la première surface (BS) ; et
une surface extérieure (SS) s'étendant de la première surface (BS) à la seconde surface (TS),
dans lequel la couche isolante (INS) est disposée sur la seconde surface (TS) du muret (BNK) et la surface extérieure (SS) du muret (BNK),
les éléments électroluminescents (LD) ne sont pas disposés sur la couche isolante (INS), et
la couche isolante (INS) recouvre entièrement la seconde surface (TS) du muret (BNK) et la surface extérieure (SS) du muret (BNK).

2. Dispositif d'affichage selon la revendication 1, dans lequel la seconde électrode (CE) est directement en contact avec la couche isolante (INS) disposée sur la seconde surface du muret (BNK).

3. Dispositif d'affichage selon la revendication 1, dans lequel la couche de vias (VIA) n'est pas disposée sur la seconde surface du muret (BNK).

4. Dispositif d'affichage selon la revendication 1 ou 3,
dans lequel la couche de vias (VIA) est en contact avec la couche isolante (INS) chevauchant la surface extérieure du muret (BNK).

5. Dispositif d'affichage selon l'une quelconque des revendications 1 à 4, dans lequel
chacun des éléments électroluminescents (LD) comprend une première extrémité et une seconde extrémité opposée à la première extrémité,
la première extrémité est directement en contact avec la première électrode (AE), et
la seconde extrémité est directement en contact avec la seconde électrode (CE).

6. Dispositif d'affichage selon la revendication 5, dans lequel
chacun des éléments électroluminescents (LD) comprend une seconde couche semi-conductrice, une couche active et une première couche semi-conductrice différente de la seconde couche semi-conductrice, qui sont empilées séquentiellement les unes sur les autres dans une troisième direction,
la première extrémité de chacun des éléments électroluminescents (LD) est adjacente à la seconde couche semi-conductrice de chacun des éléments électroluminescents (LD), et
la seconde extrémité de chacun des éléments électroluminescents (LD) est adjacente à la première couche semi-conductrice de chacun des éléments électroluminescents (LD),
éventuellement dans lequel
la première couche semi-conductrice de chacun des éléments électroluminescents (LD) est une couche semi-conductrice de type n, et
la seconde couche semi-conductrice de chacun des éléments électroluminescents (LD) est une couche semi-conductrice de type p.

7. Dispositif d'affichage selon l'une quelconque des revendications précédentes, comprenant en outre :
une couche de commande de lumière sur la seconde électrode (CE),
dans lequel la couche de commande de lumière comprend :
un premier motif de blocage de lumière séparant une zone d'émission et une zone de non-émission ;
un motif de conversion de longueur d'onde disposé dans le premier motif de blocage de lumière, et chevauchant la zone d'émission dans une vue en plan ;
un second motif de blocage de lumière disposé sur le premier motif de blocage de lumière ; et
des filtres colorés disposés sur le motif de conversion de longueur d'onde.

8. Procédé de fabrication d'un dispositif d'affichage, le procédé comprenant :
la formation d'une première électrode (AE) et d'un muret (BNK) comprenant une ouverture (OP) exposant une partie de la première électrode (AE) sur un substrat (SUB),
dans lequel le muret (BNK) recouvre une portion de bord de la première électrode (AE),
dans lequel le muret (BNK) comprend :
une première surface (BS) en contact avec le substrat (SUB),
une seconde surface (TS) opposée à la première surface (BS), et
une surface extérieure (SS) s'étendant de la première surface (BS) à la seconde surface (TS) ;
la formation d'une couche isolante (INS) sur la seconde surface (TS) du muret (BNK) et la surface extérieure (SS) du muret (BNK) ;
la formation d'éléments électroluminescents (LD) sur le substrat (SUB) ;
le retrait d'un premier sous-ensemble des éléments électroluminescents (LD), le premier sous-ensemble des éléments électroluminescents (LD) ayant été formé sur la couche isolante (INS) ;
la formation d'une couche de vias (VIA) pour remplir l'ouverture (OP) ; et
la formation d'une seconde électrode (CE) sur la couche isolante (INS), la couche de vias (VIA) et un second sous-ensemble d'éléments électroluminescents (LD), le second sous-ensemble d'éléments électroluminescents (LD) restant sur la première électrode (AE),
dans lequel la couche isolante (INS) recouvre entièrement la seconde surface (TS) du muret (BNK) et la surface extérieure (SS) du muret (BNK).

9. Procédé selon la revendication 8, dans lequel le retrait du premier sous-ensemble des éléments électroluminescents (LD) comprend :
la formation d'un motif de résine photosensible (PR) pour chevaucher la couche isolante (INS) et une portion du premier sous-ensemble des éléments électroluminescents (LD) dans une vue en plan ; et
le retrait du premier sous-ensemble des éléments électroluminescents (LD), dans lequel le motif de résine photosensible (PR) ne chevauche pas le second sous-ensemble des éléments électroluminescents (LD) dans une vue en plan.
